# EUROPEAN PATENT APPLICATION

(11) **EP 2 590 172 A2**
(43) Date of publication of application: **08.05.2013**
(21) Application number: 12185199.2
(22) Date of filing: 20.09.2012
(51) Int. Cl.: G11C 8/08

(54) **Semiconductor device including multiple-input logic circuit with operation rate balanced with driving ability**

(30) Priority: 29.09.2011 JP 2011214356
(71) Applicant: Elpida Memory, Inc., Tokyo (JP)
(72) Inventor: Dono, Chiaki, Tokyo (JP)
(74) Representative: Vossius & Partner

(57) **Abstract**

A device includes first through third logic circuits. Each of first and second logic circuits includes a first circuit portion generating a first output signal in response to a first input signal when a second input signal takes a first logic level, and a second circuit portion transferring the first input signal to output the first output signal when the second input signal takes a second logic level. The third logic circuit includes a third circuit portion generating a second output signal in response to the first output signal supplied from the first logic circuit when the first output signal supplied from the second logic circuit takes a third logic level, and a fourth circuit portion generating the second output signal in response to the first output signal supplied with the first logic circuit when the first output signal supplied from the second logic circuit takes a fourth logic level.

## Description

Background of the Invention:

### [Field of the Invention]

This invention relates to a semiconductor device including a multiple-input logic circuit.

### [Description of Related Art]

A data transfer rate is being speed up on carrying out transfer of data between a semiconductor device, for example, a DRAM (Dynamic Random Access memory) and a memory controller. Consequently, a data bus used on carrying out transfer of data is susceptible to noises or the like from the outside and it is danger of occurrence of errors to transfer data. Therefore, the semiconductor device adds a CRC (Cyclic Redundancy Check) code (an error-detecting code) generated therein to the transfer data to send it to the memory controller. And, the memory controller carries out a decision process whether or not there is any error in the transfer data on the basis of the sent transfer data and the error-detecting code. If there is any error in the transfer data, reliability of the data transfer in the data bus is improved by, for example, re-transmitting the transfer data from the semiconductor device.

By way of illustration, JP-A 2009-87485 (which will be also called Patent Document 1 and which corresponds to US 2009/0086551 A1) discloses a semiconductor device (a DRAM) having such a cyclic redundancy check function.

In the DRAM having the cyclic redundancy check function described in Patent Document 1, as an error-detecting code generating circuit for generating the error-detecting code, a multiple-input exclusive OR circuit having input terminals which correspond in number to the number of bits of the transfer data is used. Generation of the error-detecting code is carried out both upon a write operation and upon a read operation of the DRAM and an operation rate thereof has an effect on a rate of the write operation and the read operation of the DRAM. On the other hand, there may be cases where the error-detecting code generating circuit must transfer the error-detecting code via a long-distance wire according to arrangement of the error-detecting code generating circuit on a DRAM chap and a driving ability thereof has an effect of the write operation and the read operation of the DRAM in the manner which is similar to the case of the operation rate.

Accordingly, in order to improve the rate of the write operation and the read operation of the DRAM having the cyclic redundancy check function, the multiple-input exclusive OR circuit in which balance between the operation rate and the driving ability is regulated is required.

### Summary:

The present invention seeks to solve one or more of the above problems, or to improve upon those problems at least in part.

In one embodiment, there is provided a device that includes first through third logic circuits. Each of the first and the second logic circuits includes first and second input terminals receiving first and second input signals, respectively, a first output terminal outputting a first output signal, a first circuit portion configured to drive the first output terminal to generate the first output signal in response to the first input signal when the second input signal takes a first logic level, and a second circuit portion configured to transfer the first input signal to the fist output terminal to output the first output signal when the second input signal takes a second logic level that is different from the first logic level. The third logic circuit includes third and fourth input terminals receiving the first output signals supplied from the first and the second logic circuits, respectively, a second output terminal outputting a second output signal, a third circuit portion configured to drive the second output terminal to generate the second output signal in response to the first output signal supplied from the first logic circuit when the first output signal supplied from the second logic circuit takes a third logic level, and a fourth circuit portion configured to drive the second output terminal to generate the second output signal in response to the first output signal supplied from the first logic circuit when the first output signal supplied from the second logic circuit takes a fourth logic level that is different from the third logic level.

### Brief Description of the Drawings:

The above features and advantages of the present invention will be more apparent from the following description of certain preferred embodiments taken in conjunction with the accompanying drawings, in which:
Fig. 1A is a circuit diagram showing a configuration of an exclusive NOR circuit XNR_C (a 2-input exclusive NOR circuit);
Fig. 1B is a circuit symbol of the exclusive NOR circuit XNR_C illustrated in Fig. 1A;
Fig. 2A is a circuit diagram showing a configuration of an exclusive OR circuit XOR_D (a 2-input exclusive OR circuit);
Fig. 2B is a circuit symbol of the exclusive OR circuit XOR_D illustrated in Fig. 2A;
Fig. 3A is a circuit diagram showing a configuration of an exclusive NOR circuit XNR_E (a 2-input exclusive NOR circuit);
Fig. 3B is a circuit symbol of the exclusive NOR circuit XNR_E illustrated in Fig. 3A;
Fig. 4A is a circuit diagram showing a configuration of an exclusive OR circuit XOR_F (a 2-input exclusive OR circuit);
Fig. 4B is a circuit symbol of the exclusive OR circuit XOR_F illustrated in Fig. 3A;
Fig. 5 is a circuit diagram showing a configuration of an exclusive NOR circuit XNR_G (a 4-input exclusive NOR circuit);
Fig. 6 is a circuit diagram showing a configuration of an exclusive OR circuit XOR_H (a 4-input exclusive OR circuit);
Fig. 7 is a circuit diagram showing a configuration of an exclusive NOR circuit XNR_I (an 8-input exclusive NOR circuit);
Fig. 8 is a circuit diagram showing a configuration of an exclusive OR circuit XOR_J (an 4-input exclusive OR circuit);
Fig. 9 is a block diagram showing a configuration of a semiconductor device 10;
Fig. 10 is a block diagram showing a configuration of an error-detecting code generating circuit 20 for use in the semiconductor device 10 illustrated in Fig. 9;
Fig. 11 is a view showing a logic of an error-detecting code generation;
Fig. 12 is a block diagram showing a configuration of a multiple-input exclusive OR circuit XOR_i for use in a 72-input exclusive OR circuit 102b of an 8-bit CRC code generating circuit 102 of the error-detecting code generating circuit 20 illustrated in Fig. 10;
Fig. 13 is a timing chart of a write operation (eight IO inputs) of the semiconductor device 10 illustrated in Fig. 9;
Fig. 14 is a timing chart of a read operation (eight IO outputs) of the semiconductor device 10 illustrated in Fig. 9;
Fig. 15 is a timing chart of a write operation (four IO inputs) of the semiconductor device 10 illustrated in Fig. 9; and
Fig. 16 is a timing chart of a read operation (four IO outputs) of the semiconductor device 10 illustrated in Fig. 9.

### Detailed Description of Preferred Embodiments:

The invention will be now described herein with reference to illustrative embodiments. Those skilled in the art will recognize that many alternative embodiments can be accomplished using the teachings of the present invention and that the invention is not limited to the embodiments illustrated for explanatory purposes.

### [First Exemplary Embodiment]

Now, referring to attached drawings, the description will proceed to preferred exemplary embodiment of this invention.

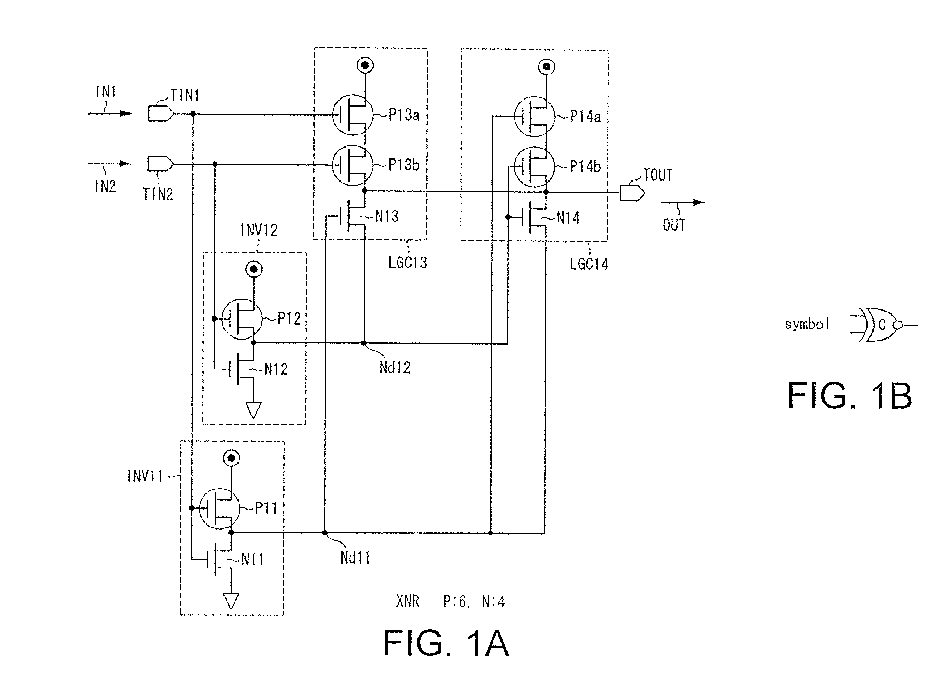

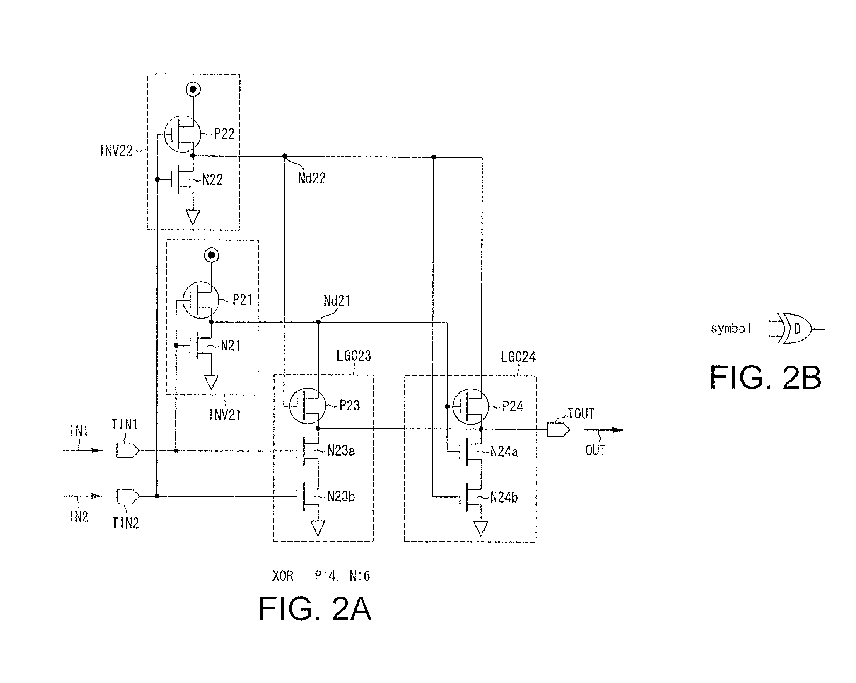

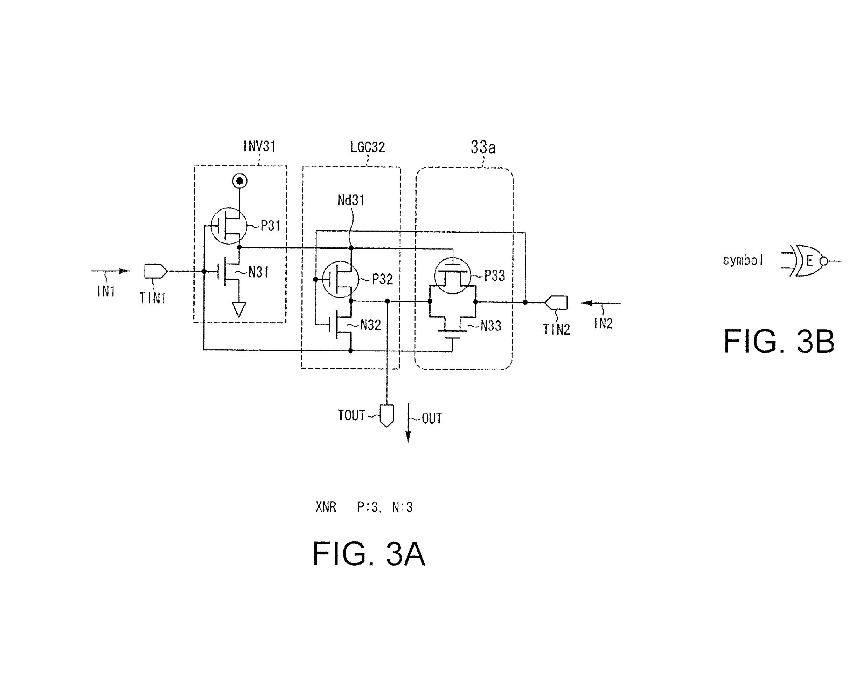

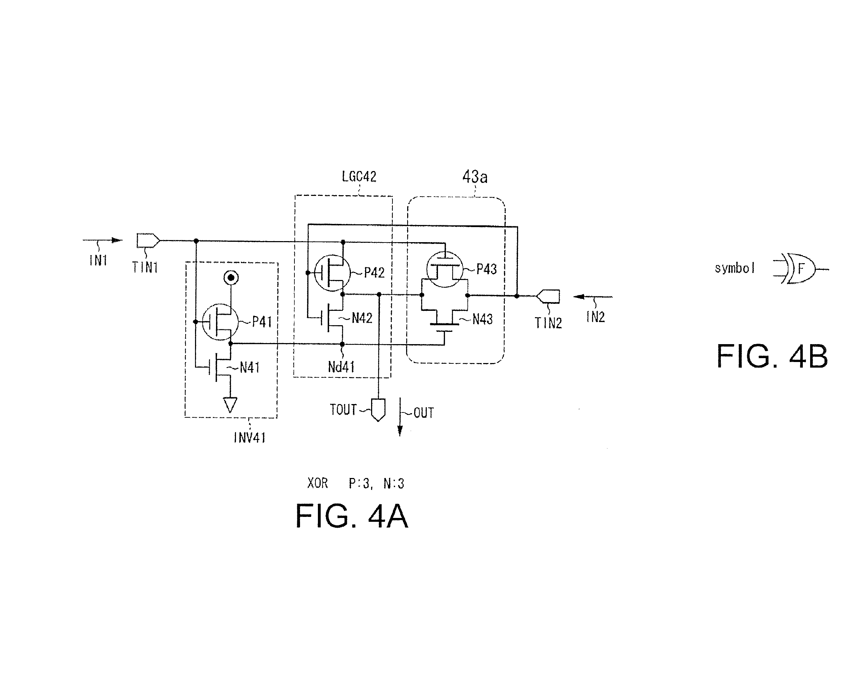

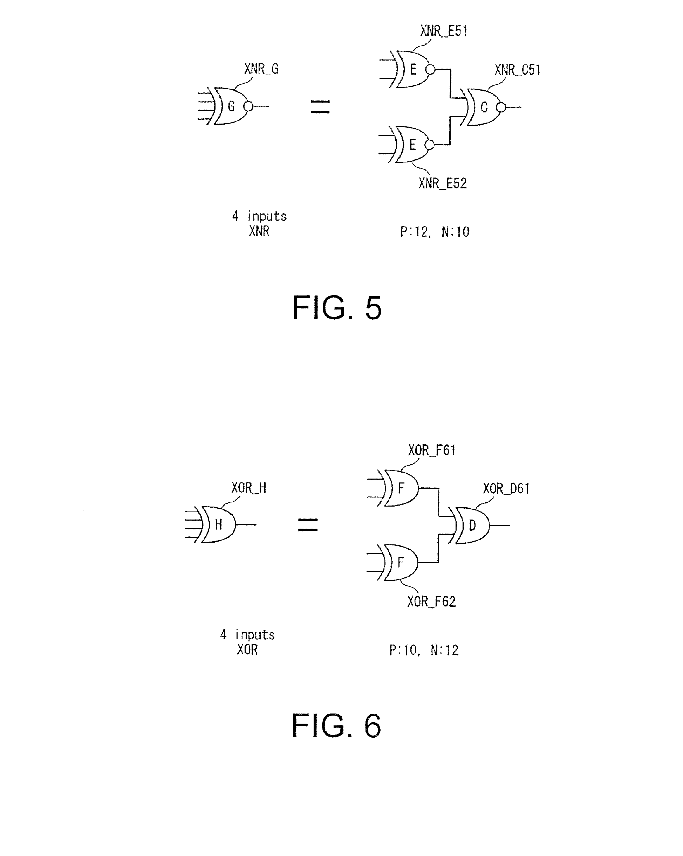

In description of a first exemplary embodiment, first, the description will proceed to configurations of an exclusive NOR circuit XNR_C and an exclusive OR circuit XOR_D (a first 2-input logic circuit) with reference to Figs. 1 and 2, subsequently, the description will proceed to configurations of an exclusive NOR circuit XNR_E and an exclusive OR circuit XOR_F (a second 2-input logic circuit) with reference to Figs. 3 and 4. Thereafter, the description will proceed to an exclusive NOR circuit XNR_G, an exclusive OR circuit XOR_H, an exclusive NOR circuit XNR_I, and an exclusive OR circuit XOR_J (a multiple-input exclusive OR circuit) with reference to Figs. 5 through 8.

Fig. 1A is a circuit diagram showing a configuration of the exclusive NOR circuit XNR_C.

The exclusive NOR circuit XNR_C (the first 2-input logic circuit) has an input terminal TIN1, an input terminal TIN2, and an output terminal TOUT. When a logic level (hereinafter, the logic level on a logic "0" makes an L level and the logic level on a logic "1" makes an H level) of an input signal IN1 supplied the input terminal TIN1 coincides to a logic level of an input signal IN2 supplied to the input terminal TIN2, the exclusive NOR circuit XNR_C produces an output signal OUT of the H level from the output terminal TOUT. When the logic level of the input signal IN1 does not coincide to the logic level of the input signal IN2, the exclusive NOR circuit XNR_C produces the output signal OUT of the L level

The exclusive NOR circuit XNR_C comprises an inverter circuit INV11, an inverter circuit INV12, a logic portion LGC13, and a logic portion LGC14.

The inverter circuit INV11 comprises a PMOS transistor P11 (a P-type channel MOS transistor) and an NMOS transistor N11 (an N-type channel MOS transistor). In the PMOS transistor P11, a source is connected to a first power supply wiring supplied with a first power supply voltage VDD, a gate is connected to the input terminal TIN1, and a drain is connected to a connection node Nd11. In the NMOS transistor N11, a drain is connected to the connection node Nd11, a gate is connected to the input terminal TIN1, and a source is connected to a second power supply wiring supplied with a second power supply voltage VSS (is grounded).

The inverter circuit INV11 inverts a logic level of the input signal IN1 supplied to the input terminal TIN1 to produce a first inverted signal to the connection node Nd11.

The inverter circuit INV12 comprises a PMOS transistor P12 and an NMOS transistor N12. In the PMOS transistor P12, a source is connected to the first power supply wiring supplied with the first power supply voltage VDD, a gate is connected to the input terminal TIN2, and a drain is connected to a connection node Nd12. In the NMOS transistor N12, a drain is connected to the connection node Nd12, a gate is connected to the input terminal TIN2, and a source is grounded.

The inverter circuit INV12 inverts a logic level of the input signal IN2 supplied to the input terminal TIN2 to produce a second inverted signal to the connection node Nd12.

The logic portion LGC13 comprises a PMOS transistor P13a, a PMOS transistor P13b, and an NMOS transistor N13. In the PMOS transistor P13, a source is connected to the first power supply wiring supplied with the first power supply voltage VDD, a gate is connected to the input terminal TIN1, and a drain is connected to a source of the PMOS transistor P13b. In the PMOS transistor P13b, the source is connected to the drain of the PMPS transistor P13a, a gate is connected to the input terminal TIN2, and a drain is connected to the output terminal TOUT. In the NMOS transistor N13, a drain is connected to the output terminal TOUT, a gate is connected to the connection node Nd11, and a source is connected to the connection node Nd12.

The logic portion LGC14 comprises a PMOS transistor P14a, a PMOS transistor P14b, and an NMOS transistor N14. In the PMOS transistor P14a, a source is connected to the first power supply wiring supplied with the first power supply voltage VDD, a gate is connected to the connection node Nd11, and a drain is connected to a source of the PMOS transistor P14b. In the PMOS transistor P14b, the source is connected to the drain of the PMOS transistor P14a, a gate is connected to the connection node Nd12, and a drain is connected to the output terminal TOUT. In the NMOS transistor N14, a drain is connected to the output terminal TOUT, a gate is connected to the connection node Nd12, and a source is connected to the connection node Nd11.

In the exclusive NOR circuit XNR_C, when the logic level of the input signal IN1 and the logic level of the input signal IN2 take the L level, the inverter circuit INV11 puts the connection node Nd11 at the H level on charge and the inverter circuit INV12 puts the connection node Nd12 at the H level on charge.

The PMOS transistor P14a and the PMOS transistor P14b are turned off (are nonconducting) and the NMOS transistor N13 and the NMOS transistor N14 are turned off because a potential difference between the gate and the source becomes zero volts. On the other hand, inasmuch as the PMOS transistor P13a and the PMOS transistor P13b are turned on (are conducting), the exclusive NOR circuit XNR_C produces the output signal OUT of the H level at the output terminal TOUT.

In the exclusive NOR circuit XNR_C, when the logic level of the input signal IN1 takes the L level and the logic level of the input signal IN2 takes the H level, the inverter circuit INV11 puts the connection node Nd11 at the H level on charge and the inverter circuit INV12 puts the connection node Nd12 at the L level on discharge.

The PMOS transistor P13a is turned on while the PMOS transistor P13b is turned off and the PMOS transistor P14a is turned on while the PMOS transistor P14b is turned off. In addition, the NMOS transistor N14 is turned off because a potential difference between the gate and the source becomes negative. On the other hand, inasmuch as the NMOS transistor is turned on because a potential difference between the gate and the source becomes positive, the exclusive NOR circuit XNR_C produces the output signal OUT of the L level at the output terminal TOUT.

In addition, in the exclusive NOR circuit XNR_C, when the logic level of the input signal IN1 takes the H level and the logic level of the input signal IN2 takes the L level, the inverter circuit INV11 puts the connection node Nd11 at the L level on discharge and the inverter circuit INV12 puts the connection node Nd12 at the H level on charge.

The PMOS transistor P13b is turned on while the PMOS transistor P13a is turned off and the PMOS transistor P14a is turned on which the PMOS transistor P14b is turned off. In addition, the NMOS transistor N13 is turned off because a potential difference between the gate and the source becomes negative. On the other hand, inasmuch as the NMOS transistor N14 is turned on because a potential difference between the gate and the source becomes positive, the exclusive NOR circuit XNR_C produces the output signal OUT of the L level at the output terminal TOUT.

In the exclusive NOR circuit XNR_C, when the logic level of the input signal IN1 and the logic level of the input signal IN2 take the H level, the inverter circuit INV11 puts the connection node Nd11 at the L level on discharge and the inverter circuit INV12 puts the connection node Nd12 at the L level on discharge.

The PMOS transistor P13a and the PMOS transistor P13b are tuned off. In addition, the NMOS transistor N13 and the NMOS transistor N14 are tuned off because a potential difference between the gate and the source becomes zero volts. On the other hand, inasmuch as the PMOS transistor P14a and the PMOS transistor P14b are turned on, the exclusive NOR circuit XNR_C produces the output signal OUT of the H level at the output terminal TOUT.

In the manner which is described above, the exclusive NOR circuit XNR_C comprises a 2-input exclusive NOR circuit which produces the output signal OUT of the H level when the logic level of the input signal IN1 coincides with the logic level of the input signal IN2 and which produces the output signal OUT of the L level when the logic level of the input signal IN1 does not coincide with the logic level of the input signal IN2.

The exclusive NOR circuit XNR_C comprises six PMOS transistors and four NMOS transistors as shown in Fig. 1A. There may be cases where the exclusive NOR circuit XNR_C is indicated by using a circuit symbol shown in Fig. 1B in drawings from Fig. 5.

Fig. 2A is a circuit diagram showing a configuration of the exclusive OR circuit XOR_D.

The exclusive OR circuit XOR_D (the first 2-input logic circuit) has a input terminal TIN1, a input terminal TIN2, and an output terminal TOUT. The exclusive OR circuit XOR_D produces an output signal OUT of an L level from the output terminal TOUT when a logic level of an input signal IN1 supplied to the input terminal TIN1 coincides with a logic level of an input signal IN2 supplied to the input terminal TIN2. In addition, the exclusive OR circuit XOR_D produces the output signal OUT of a H level when the logic level of the input signal IN1 does not coincide with the logic level of the input signal IN2.

The exclusive OR circuit XOR_D comprises an inverter circuit INV21, an inverter circuit INV22, and a logic portion LGC23, and a logic portion LGC24.

The inverter circuit INV21 comprises a PMOS transistor P21 and an NMOS transistor N21. In the PMOS transistor P21, a source is connected to the first power supply wiring supplied with the first power supply voltage VDD, a gate is connected to the input terminal TIN1, and a drain is connected to a connection node Nd21. In the NMOS transistor N21, a drain is connected to the connection node Nd21 a gate is connected to the input terminal TIN1, and a source is grounded.

The inverter circuit INV21 inverts the logic level of the input signal IN1 supplied to the input terminal TIN1 to produce a first inverted signal to the connection node Nd21.

The inverter circuit INV22 comprises a PMOS transistor P22 and an NMOS transistor N22. In the PMOS transistor P22, a source is connected to the first power supply wiring supplied with the first power supply voltage VDD, a gate is connected to the input terminal TIN2, and a drain is connected to a connection node Nd22. In the NMOS transistor N22, a drain is connected to the connection node Nd22, a gate is connected to the input terminal TIN2, and a source is grounded.

The inverter circuit INV22 inverts the logic level of the input signal IN2 supplied to the input terminal TIN2 to produce a second inverted signal to the connection node Nd22.

The logic portion LGC23 comprises a PMOS transistor P23, an NMOS transistor N23a, and an NMOS transistor N23b. In the PMOS transistor P23, a source is connected to the connection node Nd21, a gate is connected to the connection node Nd22, and a drain is connected to the output terminal TOUT. In the NMOS transistor N23a, a drain is connected to the output terminal TOUT, a gate is connected to the input terminal TIN1, and a source is connected to a drain of the NMOS transistor N23b. In the NMOS transistor N23b, the drain is connected to the source of the NMOS transistor N23a, a gate is connected to the input terminal TIN2, and a source is grounded.

The logic portion LGC24 comprises a PMOS transistor P24, an NMOS transistor N24a, and an NMOS transistor N24b. In the PMOS transistor P24, a source is connected to the connection node Nd22, a gate is connected to the connection node Nd21, and a drain is connected to the output terminal TOUT. In the NMOS transistor N24a, a drain is connected to the output terminal TOUT, a gate is connected to the connection node Nd21, and a source is connected to a drain of the NMOS transistor N24b. In the NMOS transistor N23b, the drain is connected to the source of the NMOS transistor N24a, a gate is connected to the connection node Nd22, and a source is grounded.

In the exclusive OR circuit XOR_D, when the logic level of the input signal IN1 and the logic level of the input signal IN2 take the L level, the inverter circuit INV21 puts the connection node Nd21 at the H level on charge while the inverter circuit INV22 puts the connection node Nd22 at the H level on charge.

The PMOS transistor P23 and the PMOS transistor P24 are turned off and the NMOS transistor N23a and the NMOS transistor N23b are turned off because a potential of the gate has the L level. On the other hand, inasmuch as the NMOS transistor N24a and the NMOS transistor N24b are turned on, the exclusive OR circuit XOR_D produces the output signal OUT having the L level at the output terminal TOUT.

In the exclusive OR circuit XOR_D, when the logic level of the input signal IN1 takes the L level and the logic level of the input signal IN2 takes the H level, the inverter circuit INV21 puts the connection node Nd21 at the H level on charge while the inverter circuit INV22 puts the connection node Nd22 at the L level on discharge.

The NMOS transistor N23b is turned on while the NMOS transistor N23a is turned off. In addition, the NMOS transistor N24a is turned on while the NMOS transistor N24b is turned off. Furthermore, the PMOS transistor P24 is turned off because a potential difference between the gate and the source becomes positive. On the other hand, inasmuch as the PMOS transistor P23 is turned on because a potential difference between the gate and the source becomes negative, the exclusive OR circuit XOR_D produces the output signal OUT having the H level at the output terminal TOUT.

In the exclusive OR circuit XOR_D, when the logic level of the input signal IN1 takes the H level and the logic level of the input signal IN2 takes the L level, the inverter circuit INV21 puts the connection node Nd21 at the L level on discharge while the inverter circuit INV22 puts the connection node Nd22 at the H level on charge.

The NMOS transistor N23a is turned on while the NMOS transistor N23b is turned off. In addition, the NMOS transistor N24b is turned on while the NMOS transistor N24a is turned off. Furthermore, the PMOR transistor P23 is turned off because a potential difference between the gate and the source becomes positive. On the other hand, inasmuch as the PMOS transistor P24 is turned on because a potential difference between the gate and the source becomes negative, the exclusive OR circuit XOR_D produces the output signal OUT having the H level at the output terminal TOUT.

In the exclusive OR circuit XOR_D, when the logic level of the input signal IN1 and the logic level of the input signal IN2 take the H level, the inverter circuit INV21 puts the connection node Nd21 at the L level on discharge while the inverter circuit INV22 puts the connection node Nd22 at the L level on discharge.

The PMOS transistor P23 and the PMOS transistor P24 are turned off because a potential difference between the gate and the source becomes zero volts and the NMOS transistor N24a and the NMOS transistor N24b are turned off because a potential of the gate has the L level. On the other hand, inasmuch as the NMOS transistor N23a and the NMOS transistor N23b are turned off, the exclusive OR circuit XOR_D produces the output signal OUT having the L level at the output terminal TOUT.

In the manner which is described above, the exclusive OR circuit XOR_D comprises a 2-input exclusive OR circuit which produces the output signal OUT having the L level when the logic level of the input signal IN1 coincides with the logic level of the input signal IN2 and which produces the output signal OUT having the H level when the logic level of the input signal IN1 does not coincide with the logic level of the input signal IN2.

In addition, the exclusive OR circuit XOR_D comprises four PMOS transistors and six NMOS transistors as shown in Fig. 2A. There may be cases where the exclusive OR circuit XOR_D is indicated by using a circuit symbol shown in Fig. 2B in drawings from Fig. 5.

Next, referring to Figs. 3A and 4A, the description will proceed to configurations of the exclusive NOR circuit XNR_E and the exclusive OR circuit XOR_F (a second 2-input logic circuit) which have a small footprint of the semiconductor device and have a small driving ability in comparison with the above-mentioned exclusive NOR circuit XNR_C and the above-mentioned exclusive OR circuit XOR_D (the first 2-input logic circuit), respectively.

Fig. 3A is a circuit diagram showing a configuration of the exclusive NOR circuit XNR_E.

The exclusive NOR circuit XNR_E (the second 2-input logic circuit) has an input terminal TIN1, an input terminal TIN2, and an output terminal TOUT. The exclusive NOR circuit XNR_E produces an output signal OUT having the H level from the output terminal TOUT when a logic level of an input signal IN1 supplied to the input terminal TIN1 coincides with a logic level of an input signal IN2 supplied to the input terminal TIN2. In addition, the exclusive NOR circuit XNR_E produces the output signal OUT having the L level when the logic level of the input signal IN1 does not coincide with the logic level of the input signal IN2.

The exclusive NOR circuit XNR_E comprises an inverter circuit INV31, a logic circuit LOG32, and a transfer gate circuit 33a.

The inverter circuit INV31 comprises a PMOS transistor P31 and an NMOS transistor N31. In the PMOS transistor P31, a source is connected to the first power supply wiring supplied with the first power supply voltage VDD, a gate is connected to the input terminal TIN1, and a drain is connected to a connection node Nd31. In the NMOS transistor N31, a drain is connected to the connection node Nd31, a gate is connected to the input terminal TIN1, and a source is grounded.

The inverter circuit INV31 inverts the logic level of the input signal IN1 supplied to the input terminal TIN1 to produce an inverted signal at the connection node Nd31.

The logic circuit LGC 32 comprises a PMOS transistor P32 and an NMOS transistor N32. In the PMOS transistor P32, a source is connected to the connection node Nd31, a gate is connected to the input terminal TIN2, and a drain is connected to the output terminal TOUT. In addition, in the NMOS transistor N32, a drain is connected to the output terminal TOUT, a gate is connected to the input terminal TIN2, and a source is connected to the input terminal TIN1.

The transfer gate circuit 33a comprises a PMOS transistor P33 and an NMOS transistor N33. In the PMOS transistor P33, a source is connected to the input terminal TIN2, a gate is connected to the connection node Nd31, and a drain is connected to the output terminal TOUT. In the NMOS transistor N33, a drain is connected to the input terminal TIN2, a gate is connected to the input terminal TIN1, and a source is connected to the output terminal TOUT.

In the exclusive NOR circuit XNR_E, when the logic level of the input signal IN1 and the logic level of the input signal IN2 take the L level, the transistors in the respective circuits carry out as follows.

First, the inverter circuit INV31 puts the connection node Nd31 at the H level on charge. In addition, in the logic circuit LGC32, gate potentials of the PMOS transistor P32 and the NMOS transistor N32 become the L level.

Therefore, in the transfer gate circuit 33a, the PMOS transistor P33 is turned off because a potential difference between the gate and the source becomes zero volts and the NMOS transistor N33 is turned off because a gate potential becomes the L level.

In addition, in the logic circuit LGC32, the NMOS transistor N32 is turned off because a potential difference between the gate and the source becomes zero volts. On the other hand, in the logic circuit LGC32, the PMOS transistor P32 is turned on because a potential difference between the gate and the source becomes negative.

As a result of this, the exclusive NOR circuit XNR_E produces the output signal OUT having the H level at the output terminal TOUT.

In addition, in the exclusive NOR circuit XNR_E, when the logic level of the input signal IN1 takes the L level and the logic level of the input signal IN2 takes the H level, the transistors in the respective circuits carry out as follows.

First, the inverter circuit INV31 puts the connection node Nd31 at the H level on charge. In addition, in the logic circuit LGC32, gate potentials of the PMOS transistor P32 and the NMOS transistor N32 become the H level.

Therefore, in the transfer gate circuit 33a, the PMOS transistor P33 is turned off because a potential difference between the gate and the source becomes zero volts and the NMOS transistor N33 is turned off because the gate potential becomes the L level.

In addition, in the logic circuit LGC32, the PMOS transistor P32 is turned off because a potential difference between the gate and the source becomes zero volts. On the other hand, in the logic circuit LGC32, the NMOS transistor N32 is turned on because a potential difference between the gate and the source becomes positive.

As a result of this, the exclusive NOR circuit XNR_E produces the output signal OUT having the L level at the output terminal TOUT.

In addition, in the exclusive NOR circuit XNR_E, when the logic level of the input signal IN1 takes the H level and the logic level of the input signal IN2 takes the L level, the transistors in the respective circuits carry out as follows.

First, the inverter circuit INV31 puts the connection node Nd31 at the L level on discharge. In addition, in the logic circuit LGC32, gate potentials of the PMOS transistor P32 and the NMOS transistor N32 become the L level.

Therefore, in the logic circuit LGC32, the PMOS transistor P32 is turned off because a potential difference between the gate and the source becomes zero volts and the second NMOT transistor N32 is turned off because a potential difference between the gate and the source becomes negative.

In addition, the transfer gate circuit 33a, the PMOS transistor P33 is turned on while a potential difference between the gate and the source becomes negative and the NMOS transistor N33 is turned off while a potential difference between the gate and the source becomes positive.

As a result of this, the exclusive NOR circuit XNR_E produces the output signal OUT having the L level at the output terminal TOUT.

In the exclusive NOR circuit XNR_E, when the logic level of the input signal IN1 and the logic level of the input signal IN2 take the H level, the transistors in the respective circuits carry out as follows.

First, the inverter circuit INV31 puts the connection node Nd31 at the L level on discharge. In addition, in the logic circuit LGC32, gate potentials of the PMOS transistor P32 and the NMOS transistor N32 become the H level.

Therefore, in the logic circuit LGC32, the NMOS transistor N32 is turned off because a potential difference between the gate and the source becomes positive and the PMOS transistor P32 is turned off because a potential difference between the gate and the source becomes zero volts.

In addition, in the transfer gate circuit 33a, the PMOS transistor P33 is turned on while a potential difference between the gate and the source becomes negative and the NMOS transistor N33 is turned on while a potential difference between the gate and the source becomes positive.

As a result of this, the exclusive NOR circuit XNR_E produces the output signal OUT having the H level at the output terminal TOUT.

In the manner which is described above, the exclusive NOR circuit XNR_E comprises a 2-input exclusive NOR circuit which produces the output signal OUT having the H level when the logic level of the input signal IN1 coincides with the logic level of the input signal IN2 and which produces the output signal OUT having the L level when the logic level of the input signal IN1 does not coincide with the logic level of the input signal IN2.

In addition, the exclusive NOR circuit XNR_E comprises three PMOS transistors and three NMOS transistors as shown in Fig. 3A.

More specifically, the exclusive NOR circuit XNR_E (the second 2-input logic circuit) has a small area as compared with the exclusive NOR circuit XNR_C (the first 2-input logic circuit) illustrated in Fig. 1A because the exclusive NOR circuit XNR_E is low in the transistors. However, the exclusive NOR circuit XNR_E comprises the transfer gate circuit 33a having a transfer gate structure and the logic circuit LGC32. The transfer gate structure passes through an input signal from a front stage (the inverter circuit INV31, a circuit for supplying a signal to the input terminal TIN2) without buffering like as an inverter circuit. For this reason, the exclusive NOR circuit XNR_E has a low driving ability as compared with the exclusive NOR circuit XNR_C.

There may be cases where the exclusive NOR circuit XNR_E is indicated by using a circuit symbol shown in Fig. 3B in drawings from Fig. 5.

Fig. 4A is a circuit diagram showing a configuration of the exclusive OR circuit XOR_F.

The exclusive OR circuit XOR_F (the second 2-input logic circuit) has an input terminal TIN1, an input terminal TIN2, and an output terminal TOUT. The exclusive OR circuit XOR_F produces an output signal OUT having the L level from the output terminal TOUT when a logic level of an input signal IN1 supplied to the input terminal TIN1 coincides with a logic level of an input signal IN2 supplied to the input terminal TIN2. In addition, the exclusive OR circuit XOR_F produces the output signal OUT having the H level when the logic level of the input signal IN1 does not coincide with the logic level of the input signal IN2.

The exclusive OR circuit XOR_F comprises an inverter circuit INV41, a logic circuit LGC42, and a transfer gate circuit 43a.

The inverter circuit INV41 comprises a PMOS transistor P41 and an NMOS transistor N41. In the PMOS transistor P41, a source is connected to the first power supply wiring supplied with the first power supply voltage VDD, a gate is connected to the input terminal TIN1, and a drain is connected to a connection node Nd41. In the NMOS transistor N41, a drain is connected to the connection node Nd41, a gate is connected to the input terminal TIN1, and a source is grounded.

The inverter circuit INV41 inverts a logic level of the input signal IN1 supplied to the input terminal TIN1 to produce an inverted signal at the connection node Nd41.

The logic circuit LGC41 comprises a PMOS transistor P42 and an NMOS transistor N42. In the PMOS transistor P42, a source is connected to the input terminal TIN1, a gate is connected to the input terminal TIN2, and a drain is connected to the output terminal TOUT. In addition, in the NMOS transistor N42, a drain is connected to the output terminal TOUT, a gate is connected to the input terminal TIN2, and a source is connected to the connection node Nd41.

The transfer gate circuit 43a comprises a PMOS transistor P43 and an NMOS transistor P43. In the PMOS transistor P43, a source is connected to the input terminal TIN2, a gate is connected to the input terminal TIN1, and a drain is connected to the output terminal TOUT. In addition, in the NMOS transistor N43, a drain is connected to the input terminal TIN2, a gate is connected to the connection node Nd41, and a source is connected to the output terminal TOUT.

In the exclusive OR circuit XOR_F, when the logic level of the input signal IN1 and the logic level of the input signal IN2 take the L level, the transistors in the respective circuits carry out as follows.

First, the inverter circuit INV41 puts the connection node Nd41 at the H level on charge. In addition, in the logic circuit LGC42, gate potentials of the PMOS transistor P42 and the NMOS transistor N42 become the L level.

Therefore, in the logic circuit LGC32, the PMOS transistor P42 is turned off because a potential difference between the gate and the source becomes zero volts and the NMOS transistor N42 is turned off because a gate potential becomes the L level. In addition, in the transfer gate circuit 43a, the PMOS transistor P43 is turned off because a gate potential becomes the L level. On the other hand, the NMOS transistor N43 is turned on because a potential difference between the gate and the source becomes positive.

As a result of this, the exclusive OR circuit XOR_F produces the output signal OUT having the L level at the output terminal TOUT.

In addition, in the exclusive OR circuit XOR_F, when the logic level of the input signal IN1 takes the L level and the logic level of the input signal IN2 takes the H level, the transistors in the respective circuits carry out as follows.

First, the inverter circuit INV41 puts the connection node Nd41 at the H level on charge. In addition, in the logic circuit LGC42, gate potentials of the PMOS transistor P42 and the NMOS transistor N42 become the H level.

Therefore, in the logic circuit LGC42, the PMOS transistor P42 is turned off because a potential difference between the gate and the source becomes positive and the NMOS transistor N42 is turned off because a potential difference between the gate and the source becomes zero volts.

In addition, in the transfer gate circuit 43a, the PMOS transistor P43 is turned on while a potential difference between the gate and the source is negative and the NMOS transistor N43 is turned on while a gate potential is positive.

As a result of this, the exclusive OR circuit XOR_F produces the output signal OUT having the H level at the output terminal TOUT.

In addition, in the exclusive OR circuit XOR_F, when the logic level of the input signal IN1 takes the H level and the logic level of the input signal IN2 takes the L level, the transistors in the respective circuits carry out as follows.

First, the inverter circuit INV41 puts the connection node Nd41 at the L level on discharge. In addition, in the logic circuit LGC42, gate potentials of the PMOS transistor P42 and the NMOS transistor N42 become the L level.

Therefore, in the transfer gate circuit 43a, the PMOS transistor P43 is turned off because a potential difference between the gate and the source is positive and the NMOS transistor N43 is turned off because a gate potential is the L level. In addition, in the logic circuit LGC42, the NMOS transistor N42 is turned off because the gate potential becomes the L level. On the other hand, the PMOS transistor P42 is turned on because the gate potential is the L level.

As a result of this, the exclusive OR circuit XOR_F produces the output signal OUT having the H level at the output terminal TOUT.

In addition, in the exclusive OR circuit XOR_F, when the logic level of the input signal IN1 and the logic level of the input signal IN2 take the H level, the transistors in the respective circuits carry out as follows.

First, the inverter circuit INV41 puts the connection node Nd41 at the L level on discharge. In addition, in the logic circuit LGC42, gate potentials of the PMOS transistor P42 and the NMOS transistor N42 become the H level.

Therefore, in the transfer gate circuit 43a, the PMOS transistor P43 is turned off because a gate potential is the H level and the NMOS transistor N43 is turned off because a gate potential is the L level. In addition, in the logic circuit LGC42, the PMOS transistor P42 is turned off because a potential difference between the gate and the source is zero volts. On the other hand, the NMOS transistor N42 is turned on because a potential difference between the gate and the source becomes positive.

As a result of this, the exclusive OR circuit XOR_F produces the output signal OUT having the L level at the output terminal TOUT.

In the manner which is described above, the exclusive OR circuit XOR_F comprises a 2-input exclusive OR circuit which produces the output signal OUT having the L level when the logic level of the input signal IN1 coincides with the logic level of the input signal IN2 and which produces the output signal OUT having the H level when the logic level of the input signal IN1 does not coincide with the logic level of the input signal IN2,

In addition, the exclusive OR circuit XOR_F comprises three PMOS transistors and three NMOS transistors as shown in Fig. 4A.

More specifically, the exclusive OR circuit XOR_F (the second 2-input logic circuit) has a small area as compared with the exclusive OR circuit XOR_D (the first 2-input logic circuit) illustrated in Fig. 2A because the exclusive OR circuit XOR_F is low in the transistors. However, the exclusive OR circuit XOR_F comprises the transfer gate circuit 43a having a transfer gate structure and the logic circuit LGC42. The transfer gate structure passes through an input signal from a front stage (the inverter circuit INV41, a circuit for supplying a signal to the input terminal TIN2) without buffering like as an inverter circuit. For this reason, the exclusive OR circuit XOR_F has a low driving ability as compared with the exclusive OR circuit XOR_D.

There may be cases where the exclusive OR circuit XOR_F is indicated by using a circuit symbol shown in Fig. 4B in drawings from Fig. 5.

Next, referring to Figs. 5 through 8, the description will proceed to configurations of the exclusive NOR circuit XNR_G, the exclusive OR circuit XOR_H, the exclusive NOR circuit XNR_I, and the exclusive OR circuit XOR_J (the multiple-input exclusive OR circuit).

Fig. 5 shows a configuration of the exclusive NOR circuit XNR_G (a 4-input exclusive NOR circuit) as an example of a multiple-input logic circuit which includes three or more input terminals and which carries out a logic operation on logic levels of the three or more input terminals.

The exclusive NOR circuit XNR_G comprises two exclusive NOR circuit XNR_E51 and XNR_E52, and one exclusive NOR circuit XNR_C51.

Each of the exclusive NOR circuit XNR_E51 and the exclusive NOR circuit XNR_E52 comprises a 2-input exclusive NOR circuit which is similar in structure to the 2-input exclusive NOR circuit XNR_E (the second 2-input logic circuit) shown in Fig. 3B.

In addition, the exclusive NOR circuit XNR_C51 comprises a 2-input exclusive NOR circuit which is similar in structure to the 2-input exclusive NOR circuit (the first 2-input logic circuit) shown in Fig. 1B.

The 4-input 1-output exclusive NOR circuit XNR_G is composed by connecting total two output terminals of the exclusive NOR circuit XNR_E51 and the exclusive NOR circuit XNR_E52 to two input terminals of the exclusive NOR circuit XNR_C51.

Therefore, the exclusive NOR circuit XNR_G produces an output signal having the H level (logic "1") form an output terminal when there are even number of the L levels among four input logic levels (all four H levels, two L levels, and all four L levels). In addition, the exclusive NOR circuit XNR_G produces the output signal having the L level (logic "0") when there are odd number of the L levels among the four input logic levels (one L level, three L levels).

The exclusive NOR circuit XNR_G has a feature where, among the 2-input exclusive NOR circuits constituting the logic circuit in question, the exclusive NOR circuit XNR_C (the first 2-input logic circuit) having a large driving ability is used as the last stage 2-input exclusive NOR circuit having an output pin and the exclusive NOR circuits XNR_E (the second 2-input logic circuit) having a small-footprint and a small driving ability as compared with the exclusive NOR circuit XNR_C are used the first stage circuits for supplying signals to the exclusive NOR circuit XNR_C.

By using this combination, it is possible to reduce the number of the MOS transistors constituted by twenty-two (twelve PMOS transistors and ten NMOS transistors) although thirty MOS transistors (eighteen PMOS transistors and twelve NMOS transistors) are required in a case where the exclusive NOR circuit is composed of three exclusive NOR circuits XNR_C.

As compared with a case where all is composed of the 2-input exclusive NOR circuits having the same driving activity with the number of the MOS transistors reduced, it is possible for the exclusive NOR circuit XNR_G to regulate a fan-out (a coefficient indicating that a capacity of a load-side circuit element corresponds to the number of a capacity of driving-side circuit elements) from an input stage to an output stage, to ensure the optimal driving ability, and to make a timing speedup. By way of illustration, when it thinks of a case of driving a load by connecting a plurality of stages of inverter circuits each having the same driving ability, the driving ability of the last stage inverter circuit must be regulated by matching the load. However, when the first stage inverter circuit regards the next stage inverter circuit as a load thereof, the load is identical with a load connected to the last stage, and therefore the first stage inverter circuit has a large load, it is impossible to speed up a timing of the inverter circuits connected to the plurality of multi-stages as a whole. Therefore, in a case of driving the load by connecting the inverter circuits to the plurality of multi-stages, a load becomes light in the respective inverter circuits by lowering the driving ability toward the first stage when the first stage inverter circuit regards the next stage inverter circuit as the load thereof, and it is therefore possible to speed up. In other words, the principle of this invention is the same principle in which it is possible to speed up a timing in circuits connected to a plurality of stages as a whole by lowering the driving ability of the inverter circuits toward the first stage to make the load light when the first stage regards the next stage to the load. Of course, even this case, when a parasitic capacity such as a wiring or the like is inserted between the inverter circuit and the inverter circuit, it is necessary to include, to the load, not only the inverter circuit but also the parasitic capacity. Therefore, the driving abilities always do not become lower toward the first stage, there may be a case of connecting the inverter circuit making the driving ability large in consideration of the loads up to the latter stage in the respective stages. On this account, also this application, it is not necessary for the first stage logic circuit to constitute any second 2-input logic circuits, and the first stage logic circuit may comprise the second 2-input logic circuits as at least one part, and the first 2-input logic circuits as the remainder.

Referring now Fig. 6, the description will proceed to a configuration of the exclusive OR circuit XOR_H (the multiple-input exclusive OR circuit).

Fig. 6 shows configuration of the exclusive OR circuit XOR_H (a 4-input exclusive OR circuit) as an example of the multiple-input logic circuit which includes three or more input terminals and which carries out a logic operation on logic levels of the three or more input terminals.

The exclusive OR circuit XOR_H comprises two exclusive OR circuit XOR_F61 and XOR_F62, and one exclusive OR circuit XOR_D61.

Each of the exclusive OR circuit XOR_F61 and the exclusive OR circuit XOR_F62 comprises a 2-input exclusive OR circuit which is similar in structure to the 2-input exclusive OR circuit XOR_F (the second 2-input logic circuit) shown in Fig. 4B.

In addition, the exclusive OR circuit XOR_D61 comprises a 2-input exclusive OR circuit which is similar in structure to the 2-input exclusive OR circuit XOR_D (the first 2-input logic circuit) shown in Fig. 2B.

The 4-input 1-output exclusive OR circuit XOR_H is configured by connecting total two output terminals of the exclusive OR circuit XOR_F61 and the exclusive OR circuit XOR_F62 with two input terminals of the exclusive OR circuit XOR_D61.

Therefore, the exclusive OR circuit XOR_H produces an output signal having the L level (logic "0") from an output terminal when there are even number of the L levels (four H levels, two L levels, and all four L levels) among four input logic levels. In addition, the exclusive OR circuit XOR_H produces the output signal having the H level (logic "1") when there are odd number of L levels (one L level, three L levels) among the four input logic levels.

The exclusive OR circuit XOR_H has a feature where, among the 2-input exclusive OR circuits constituting the logic circuit in question, the exclusive OR circuit XOR_D (the first 2-input logic circuit) having a large driving ability is used as the last stage 2-input exclusive OR circuit having an output pin and the exclusive OR circuits XOR_F (the second 2-input logic circuit) having a small-footprint and a small driving ability as compared with the exclusive OR circuit XOR_D are used the first stage circuits for supplying signals to the exclusive OR circuit XOR_D.

By using this combination, it is possible to reduce the number of the MOS transistors constituted by twenty-two (ten PMOS transistors and twelve NMOS transistors) although thirty MOS transistors (twelve PMOS transistors and eighteen NMOS transistors) are required in a case where the exclusive OR circuit is composed of three exclusive OR circuits XOR_D.

In addition, as compared with a case where all is composed of the 2-input exclusive OR circuits having the same driving ability with the number of the MOS transistors reduced, it is possible for the exclusive OR circuit XOR_H to ensure the optimal driving ability and to make a timing speedup. As a matter of course, the first stage logic circuits are not required to configure all of the second 2-input logic circuits. The first stage logic circuits may comprise the second 2-input logic circuits as at least one part thereof, and the first 2-input logic circuits as the remainder.

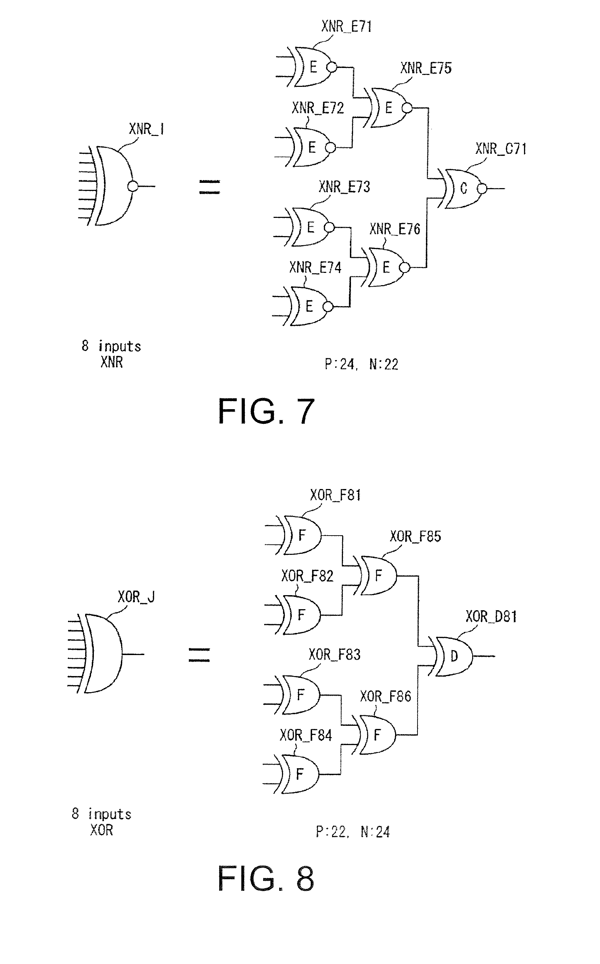

Next, referring to Figs. 7 and 8, the description will proceed to configurations of the exclusive NOR circuit XNR_I and the exclusive OR circuit XOR_J (the multiple-input exclusive OR circuit).

Fig. 7 shows a configuration of the exclusive NOR circuit XNR_I (an 8-input exclusive NOR circuit) as an example of the multiple-input logic circuit which includes three or more input terminals and which carries out a logic operation on logic level of the three or more input terminals.

The exclusive NOR circuit XNR_I comprises six exclusive NOR circuits XNR_E71 to XNR_E76 and one exclusive NOR circuit XNR_C71.

Each of the six exclusive NOR circuits XNR_E71 to XNR_E76 comprises a 2-input exclusive NOR circuit which is similar in structure to the 2-input exclusive NOR circuit XNR_E (the second 2-input logic circuit) shown in Fig. 3B.

In addition, the exclusive NOR circuit XNR_C71 comprises a 2-input exclusive NOR circuit which is similar in structure to the 2-input exclusive NOR circuit XNR_C (the first 2-input logic circuit) shown in Fig. 1B.

Total two output terminals of the exclusive NOR circuit XNR_E71 and the exclusive NOR circuit XNR_E72 are connected to two input terminals of the exclusive NOR circuit XNR_E75, total two output terminals of the exclusive NOR circuit XNR_E73 and the exclusive NOR circuit XNR_E74 are connected to two input terminals of the exclusive NOR circuit XNR_E76. In addition, total two output terminals of the exclusive NOR circuit XNR_E75 and the exclusive NOR circuit XNR_E76 are connected to two input terminals of the exclusive NOR circuit XNR_C71. With this structure, the 8-input 1-output exclusive NOR circuit XNR_I is configured.

Therefore, the exclusive NOR circuit XNR_I produces an output signal having the H level (logic "1") from an output terminal thereof when there are even number of L levels (logic "0") (all H levels, two L levels, four L levels, six L levels, and all of eight L levels) among eight input logic levels. In addition, the exclusive NOR circuit XNR_I produces the output signal having the L level (logic "0") when there are odd number of L levels (one L level, three L level, five L level, and seven L levels) among the eight input logic levels.

The exclusive NOR circuit XNR_I has a feature where, among the 2-input exclusive NOR circuits constituting the logic circuit in question, the exclusive NOR circuit XNR_C (the first 2-input logic circuit) having a large driving ability is used as the last stage 2-input exclusive NOR circuit having an output pin and the exclusive NOR circuits XNR_E (the second 2-input logic circuit) having a small-footprint and a small driving ability as compared with the exclusive NOR circuit XNR_C are used the first part circuits for supplying signals to the exclusive NOR circuit XNR_C.

By using this combination, it is possible to reduce the number of the MOS transistors constituted by forty-six (twenty-four PMOS transistors and twenty-two NMOS transistors) although seventy MOS transistors (forty-two PMOS transistors and twenty-eight NMOS transistors) are required in a case where the exclusive NOR circuit is composed of seven exclusive NOR circuits XNR_C.

As compared with a case where all is composed of the 2-input exclusive NOR circuits having the same driving ability with the number of the MOS transistors reduced, it is possible for the exclusive NOR circuit XNR_I to ensure the optimal driving ability and to make a timing speedup. This reason is similar to the reason mentioned in the exclusive NOR circuit XNR_G shown in Fig. 5. For example, in accordance with a process generation of the products implementing the semiconductor devices (a period using a manufacturing process although the manufacturing process also changes with finer design rules), the ability of the MOS transistor changes (e.g. the driving ability improves). Even such circumstances, when the load of the logic circuit is determined as a design target, it is possible to ensure the optimal driving ability and to make the timing speedup by constituting a part comprising the output stage by the first 2-input logic circuits and by constituting a first stage (two stages) supplying signals to the first 2-input logic circuits by the second 2-input logic circuits. Of course, it is unnecessary for the first stage logic circuit to constitute any second 2-input logic circuits, the first stage logic circuit may comprises the second 2-input logic circuit as at least one part, and the first 2-input logic circuits as the remainder in accordance with the load of the design target.

Fig. 8 shows a configuration of the exclusive OR circuit XOR_J (an 8-input exclusive OR circuit) as an example of the multiple-input logic circuit which includes three or more input terminals and which carries out a logic operation on logic level of the three or more input terminals.

The exclusive OR circuit XOR_J comprises six exclusive OR circuits XOR_F81 to XOR_E86 and one exclusive OR circuit XOR_D81.

Each of the six exclusive OR circuits XOR_F81 to XOR_F86 comprises a 2-input exclusive OR circuit which is similar in structure to the 2-input exclusive OR circuit XOR_F (the second 2-input logic circuit) shown in Fig. 4B.

In addition, the exclusive OR circuit XOR_D81 comprises a 2-input exclusive OR circuit which is similar in structure to the 2-input exclusive OR circuit XOR_D (the first 2-input logic circuit) shown in Fig. 2B.

Total two output terminals of the exclusive OR circuit XOR_F81 and the exclusive OR circuit XOR_F82 are connected to two input terminals of the exclusive OR circuit XOR_F85, total two output terminals of the exclusive OR circuit XOR_F83 and the exclusive OR circuit XOR_F84 are connected to two input terminals of the exclusive OR circuit XOR_F86. In addition, total two output terminals of the exclusive OR circuit XOR_F85 and the exclusive OR circuit XOR_F86 are connected to two input terminals of the exclusive OR circuit XOR_D81. With this structure, the 8-input 1-output exclusive OR circuit XOR_J is configured.

Therefore, the exclusive OR circuit XOR_J produces an output signal having the L level (logic "0") from an output terminal thereof when there are even number of L levels (logic "0") (all H levels, two L levels, four L levels, six L levels, and all of eight L levels) among eight input logic levels. In addition, the exclusive OR circuit XOR_J produces the output signal having the H level (logic "1") when there are odd number of L levels (one L level, three L level, five L level, and seven L levels) among the eight input logic levels.

The exclusive OR circuit XOR_J has a feature where, among the 2-input exclusive OR circuits constituting the logic circuit in question, the exclusive OR circuit XOR_D (the first 2-input logic circuit) having a large driving ability is used as the last stage 2-input exclusive OR circuit having an output pin and the exclusive OR circuits XOR_F (the second 2-input logic circuit) having a small-footprint and a small driving ability as compared with the exclusive OR circuit XOR_D are used the first part circuits for supplying signals to the exclusive OR circuit XOR_D.

By using this combination, it is possible to reduce the number of the MOS transistors constituted by forty-six (twenty-two PMOS transistors and twenty-four NMOS transistors) although seventy MOS transistors (twenty-eight PMOS transistors and forty-two NMOS transistors) are required in a case where the exclusive OR circuit is composed of seven exclusive OR circuits XOR_D.

In addition, as compared with a case where all is composed of the 2-input exclusive OR circuits having the same driving activity with the number of the MOS transistors reduced, it is possible for the exclusive OR circuit XOR_J to ensure the optimal driving activity and to make a timing speedup. As a matter of course, the first part logic circuits are not required to configure all of the second two-input logic circuits. It may be that at least one part is configured to the second two-input logic circuit and the first two-input logic circuits are included in the first part logic circuit as remaining in accordance with a load of design target.

In the manner which is described above, this invention is the multiple-input logic circuit which includes three or more input terminals and which carries out a logic operation on logic levels of the three or more input terminals, wherein the multiple-input logic circuit (the third and exclusive NOR circuit XNR_G, XNR_I, the third and exclusive OR circuit XOR_H, XOR_J) comprises a plurality of 2-input logic circuit each of which has two input terminals and carries out the logic operation on the logic levels of the two input terminals, wherein the plurality of 2-input logic circuits include the first 2-input logic circuit (the exclusive NOR circuit XNR_C or the exclusive OR circuit XOR_D) and the second 2-input logic circuit (the exclusive NOR circuit XNR_E or the exclusive OR circuit XOR_F) having a small-footprint and a small driving activity in comparison with the first 2-input logic circuit, wherein the first 2-input logic circuit serves as a last stage of the multiple-input logic circuit, and wherein the second 2-input logic circuit serves as at least one of a first part circuit for supplying a signal to the first 2-input logic circuit.

According to the semiconductor device according to this invention, it is possible to provide a multiple-input exclusive OR circuit in which a balance between the operational rate and the driving ability is regulated as compared with a conventional multiple-input exclusive OR circuit.

### [Second Exemplary Embodiment]

Next, the description will proceed to a semiconductor device (a semiconductor device 10) comprising an error-detecting code generating circuit which comprises the above-mentioned multiple-input exclusive OR circuit.

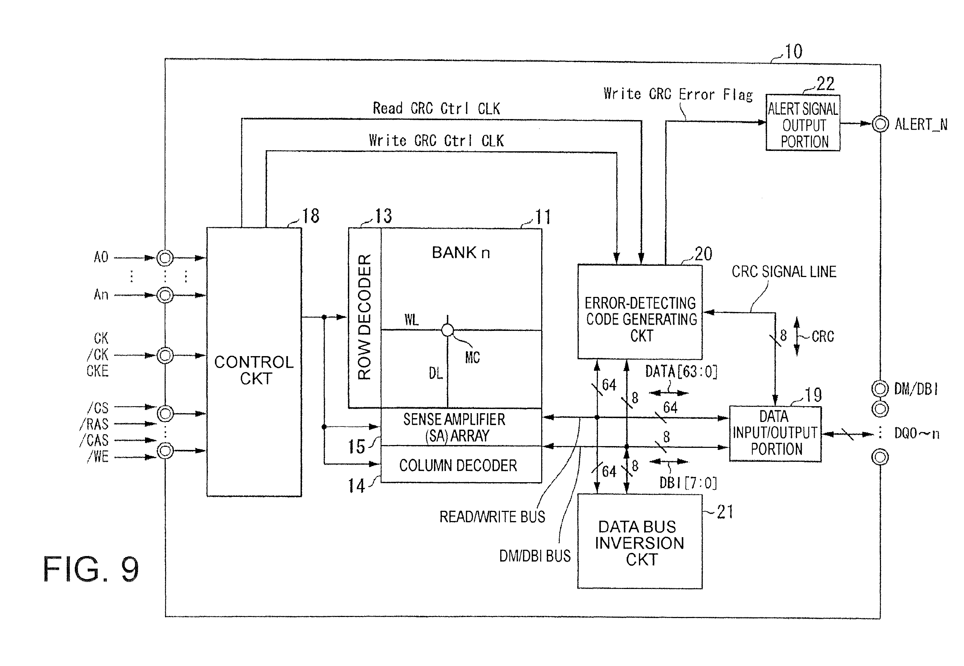

Fig. 9 shows a schematic configuration of the semiconductor device 10 in a case where the semiconductor device 10 of this invention is applied to, for example, a SDRAM (Synchronous Dynamic Random Access Memory) which operates in synchronism with a clock signal. In addition, all of each circuit block shown in Fig. 9 is formed on one semiconductor chip such as a single-crystal silicon. Each circuit block comprises a plurality of transistors, for example, PMOS transistors and NMOS transistors or the like. In addition, those depicted at ⊚ mark indicate pads as external terminals provided to the semiconductor device in question and in addition to the external terminals illustrated, power supply voltage terminals to which a power supply voltage supplied from the outside is applied are provided.

The semiconductor device 10 comprises a memory cell array 11, a row decoder 12, a column decoder 14, a sense amplifier array 15, a control circuit 18, a data input/output portion 19, an error-detecting code generating circuit 20, a data bus inversion circuit 21, and an alert signal output portion 22.

On read operation, the semiconductor device 10 generates an error-detecting code (hereunder, a CRC code) in the error-detecting code generating circuit 20 to produce the CRC code while read data is produced. Although a method of generating the CRC code may be, by way for example, a method using a cyclic redundancy check technique defined by a standardization group (JEDEC and so on), it is not limited thereto. This example takes, as an example, a case of eight IO configuration and operation of a burst length BL8 (an operation for producing memory cell data of 8x8 = 64 bits from eight data input/output terminals DQ at the burst length of eight). In this event, the CRC code of a calculated result is produced at a ninth bit of the burst length BL of the respective input/output terminals DQ.

A host CPU (a memory controller), which communicates with the semiconductor device 10, receives data and the CRC code which are transmitted from semiconductor device 10, and carries out a CRC operation on the basis of the data from transmitted from the semiconductor device 10 by oneself. The host CPU checks equality between the CRC code calculated by oneself and the CRC code transmitted from the semiconductor device 10 thereby enabling to detect whether or not data is normally transmitted at a data line between the semiconductor device and the host CPU (whether or not data is mistakenly transmitted).

On write operation, the semiconductor device 10 generates the CRC code in the error-detecting code generating circuit 10 by using the CRC technique while data is received. This example shows an example of a case of eight IO configuration and operation of BL8 (an operation of supplying data of 8x8 = 64 bits from the data input/output terminals DQ at the burst length of eight to them to the memory cells). In this event, the CRC code of a calculated result from the host CPU is supplied at a ninth bit of BL of the respective data input/output terminals DQ.

The semiconductor device 10 checks equality between the CRC code transmitted from the host CPU which communicates therewith and the CRC code generated from the received write data by oneself thereby enabling to detect whether or not data is mistakenly transmitted at the data line between the semiconductor device 10 and the host CPU. In the semiconductor device of this exemplary embodiment, a terminal called ALERT_N is standardized that produces an alert signal ALERT_N at an L level (active level) when a mistaken transmission is detected.

Although illustration is not made in Fig. 9, in a case of four IO configuration and operation of BL8 (an operation where the memory cell data of 4x8 = 32 bits is produced from the four data input/output terminals DQ at the burst length of eight), the CRC code of a calculated result is produced at ninth and tenth bits of BL of the respective data input/output terminals DQ. This is because the four I/O configuration having a small number of IO must a CRC calculated result of eight bits in total inasmuch as the number of bits of a necessary CRC calculated result is equal between the case of eight IO configuration and operation of BL of eight and the case of four IO configuration and operation of BL of four.

The description will proceed to the configuration of the semiconductor device 10 in brief in turn.

The memory cell array 11 (a memory cell array comprising memory cells corresponding to bit lines and word lines) comprises a plurality of banks in each of which a plurality of memory cells are arranged with a matrix fashion with rows and columns. In Fig. 9, a bank n is illustrated in behalf thereof. The bank n comprises the memory cells serving as a memory area. For example, the bank n comprises the memory cells MC at points of intersection of the word lines WL and the bit lines DL.

The control circuit 18 comprises a clock generating circuit therein. The clock generating circuit generates an internal clock signal for making internal circuits (a command decoder in the control circuit 18, the data input/output portion 19, and so on) operate on the basis of a clock signal CK having a constant frequency supplied from the outside, an inverted clock signal /CK obtained by logically inverting the clock signal, and a clock enable signal CKE indicative of effectiveness of the clock signal CK and the inverted clock signal /CK.

As control signals supplied to the semiconductor device 10 from the outside, there are following control signals in addition to the clock signal CK, the inverted clock signal /CK, and the clock enable signal CKE. That is, there are a chip select signal /CS (hereunder, may be an external memory control signal CS) for putting the semiconductor device 10 into a selected state, a row address strobe signal /RAS (hereunder, may be an external memory control signal RAS), a column address strobe signal /CAS (hereunder, may be an external memory control signal CAS), a write enable signal /WE (herein, may be an external memory control signal WE) for instructing a write operation of data, and so on. Those in which "/" are attached before symbols in the above-mentioned signals mean that a low level (an L level) is an effective level.

The control circuit 18 comprises the command decoder therein. The command decoder decodes a CS signal, an RAS signal, a CAS signal, and a WE signal serving as their external memory control signals and a part of an address signal, and decodes commands supplied from the outside. As the commands supplied to the semiconductor device 10 of this exemplary embodiment, there are an ACT command for instructing activation of the internal circuits of the semiconductor device, an READ command for instructing a reading-out, a WRITE command for instructing a writing-in, an MRS command for instructing setting of an operation mode for a mode register in the control circuit 18, a PRE command for instructing inactivation of the internal circuits activated by the ACT command, and so on.

The command decoder captures the CS signal, the RAS signal, the CAS signal, and WE signal serving as the external memory control signals as command signals in synchronism with the internal clock signal to decode them. In addition, the command decoder generates internal command signals corresponding to decoded commands, for example, an internal active signal, an internal write signal, an internal read signal, an internal precharge signal, and so on which correspond to an active command (ACT command), a write command (WRITE command), a read command (READ command), a precharge command (RPE command), and so on, respectively.

In addition, the control circuit 18 comprises the mode register therein. The mode register holds an address signal A0-An by a combination of active levels of the CS signal, the RAS signal, the CAS signal, and the WE signal serving as the external memory control signals and carries out an initial setting of the respective operation modes such as an entry for a test operation mode, or the like. The burst length (BL) is also set in the mode register.

The control circuit 18 generates, in response to the respective operation modes set in the mode register and the internal command signals from the command decoder, control signals for controlling respective circuits in the semiconductor device 10 (an address buffer, the row decoder 13, the column decoder 14, the sense amplifier array 15, the data input/output portion 19, the error-detecting code generating circuit 20, the data bus inversion circuit 21). By way of illustration, the control circuit 18 controls timings and produces active/inactive control signals for active-controlling the row decoder 13, the column decoder 14, the sense amplifier array 15, the data input/output portion 19, the error-detecting code generating circuit 20, and the data bus inversion circuit 21 in response to changes of the logic levels of the internal active signal and the internal precharge signal. In addition, the control circuit 18 controls timings and produces a write control signal for active-controlling the data input/output portion 19 in response to a change of the logic level of the internal write signal.

The control circuit 18 comprises the address buffer therein. The address buffer captures an address data (hereunder, abbreviated as an address) indicative of a position of the memory cell supplied from the outside in a state where it is activated by the ACT command therein in a multiplex scheme. The multiplex scheme is a scheme which captures, in time sequence, a row address indicative of a position of the memory cell by the ACT command and a column address indicative of the a position of the memory cell by the READ command and the WRITE command.

The row decoder 13 decodes the row address captured in the address buffer in a state where it is activated by the ACT command to select a corresponding word line (the above-mentioned word line WL) in the memory cell array 11. A plurality of memory cells connected to the selected word line are connected to the respective bit lines (bit lines DL if it is the memory cells MC) and data of the memory cells are read out to the bit lines.

The sense amplifier array 15 is activated by the ACT command, amplifies voltages read out to the bit lines by the internal read signal or the internal write signal, and sends amplified data as read data DATA [63:0] to the data input/output portion 19 and the error-detecting code generating circuit 20 via selected column switches and a read/write bus when the semiconductor memory 10 is put into a state (a read operation state) for reading out data from the memory cells. When the semiconductor device 10 is put into a sate (a write operation state) for writing data in the memory cells, the sense amplifier array 15 writes write data DATA [63:0] produced by the data input/output portion 19 in the memory cells via the column switches and the read/write bus on the basis of a decided result of the error-detecting code generating circuit 20.

The column decoder 14 decodes the column address captured by the address buffer in a state where it is activated by the WRITE command (or the READ command) following the ACT command to select a corresponding column (bit line) in the memory cell array 11.

In the read operation of the semiconductor device 10, the error-detecting code generating circuit 20 is activated by a control signal Read CRC Ctrl CLK supplied from the control circuit 18, generates the CRC code (eight bits) on the basis of the read data DATA [63:0] read via the read/write bus out of the memory cell array 11 and a data bus inversion signal DBI [7:0] supplied from the data bus inversion circuit 21 via a DM/DBI bus, and produces it to the data input/output portion 19 via a CRC signal line.

In the write operation of the semiconductor device 10, the error-detecting code generating circuit 20 is activated by a control signal Write CRC Ctrl CLK supplied from the control circuit 18, decides whether or not date to be written in the memory cells are correct (whether or not date received in the data input/output portion 19 are correct data) on the basis of the write data DATA [63:0] supplied from the data input/output portion 19 via the read/write bus, the data bus inversion signal DBI [7:0] supplied from the data input/output portion 19 via the read/write bus, and a CRC code CRC [7:0] (a cyclic redundancy code) supplied from the data input/output portion 19 via the CRC signal line, and supplies a decided result as a decided result signal Write CRC Error Flag to the alert signal output portion 22. The alert signal output portion 22 produces the alert signal ALERT_N at the L level (the active level) when the decided result signal Write CRC Error Flag indicates that the decided result is negative.

In the read operation of the semiconductor device 10, the data input/output portion 19 produces, to the outside via the data input/output terminals DQ0-DQn (n = 3 or 7), the read data DATA [63:0] read out of the memory cell array 11 via the read/write bus and the CRC code CRC [7:0] generated by the error-detecting code generating circuit 20.

In the write operation of the semiconductor device 10, the data input/output portion 19 supplies data to be written in the memory cells supplied from the outside via the data input/output terminals DQ0-DQn, namely, the write data DATA [63:0] to the memory cell array 11 and the error-detecting code generating circuit 20 via the read/write cut, and supplies the CRC code CRC [7:0] which is a result CRC calculated by a memory controller (not shown) of the outside to the error-detecting code generating circuit 20 via the CRC signal line.

In the manner which is described above, an input/output of the CRC code CRC [7:0] is carried out via the data input/output terminals DQ0-DOn. Therefore, it is necessary for the data input/output portion 19 to control to swap the data (the read data, the write data) between the read/write bus and the data input/output terminals DQ and to swap the CRC code between the CRC signal line (a data transmission line having eight bits) and the data input/output terminals DQ. It is therefore necessary to preliminarily set what data correspond to the CRC code among a series of data to be input/output via data input/output terminals DQ and a cluster of data of CRC code. By way of example, in this exemplary embodiment, in a case of X8IO configuration and the data burst length of BL8, the ninth bit (BL9) following to an input/output of data corresponds to the CRC code. In a case of X4IO configuration and the data burst length of BL8, two bits consisting of the ninth bit and the tenth bit following to the output of the data correspond to the CRC code. Therefore, the data input/output portion 19 comprises an FiFo (First in First out) circuit (not shown), controls to produce the CRC code CRC [7:0] from the CRC signal line at the ninth and tenth bits of the read data on reading, and supplies the CRC code CRC [7:0] from the ninth and the tenth bits of the write data to the CRC signal line on writing.

The data input/output portion 19 comprises a DM/DBI terminal. The DM/DBI terminal is a terminal for swaping a data mask signal or data bus inversion signal with the memory controller. The data input/output portion 19 is connected to the data bus inversion circuit 21 via a DM/DBI bus and carries out a swap of the data bus inversion signal DBI [7:0].

The data mask signal is a signal which is supplied to the semiconductor device 10 together with the write data from the memory controller on the write operation and which masks the corresponding write data, and is a signal which is not used on the read operation.

The data bus inversion signal is a signal which is supplied to the semiconductor device 10 from the memory controller together with the write data on the write operation and which is produced from the semiconductor device 10 to the memory controller together with the read data on the read operation. The data bus inversion signal is a signal for notifying a receiving side device (e.g. the memory controller) that whether or not a transmitting side device (e.g. the semiconductor device 10) inverts data (e.g. the read data) on outputting. The receiving side device switches, in response to the data bus inversion signal, that received data is taken as it is or that the received data is taken with inverting it. The data bus inversion signal has a function to reduce a swing count of the read data or the write data in a transmission line, for example, by taking a majority logic of data to invert a part of the data, and therefore to contribute improvement of data integrity. However, the transmitting side requires to notify a destination that inversion of data is made in the manner which is described above and the data bus inversion signal is used. The receiving side reproduces the data using the data bus inversion signal. On the reading of the semiconductor device 10, the data bus inversion signal (address logic data) is generated by the data bus inversion circuit 21. The data bus inversion signal (data address) generated on the basis of the write data transmitted from the memory controller is supplied to the data input/output portion 19 via the DM/DBI terminal.

Inasmuch as a function of the data mask signal has directly no bearing on this application, in the inside of the semiconductor device 10, the data bus inversion signal is nod indicated as DM/DBI [7:0] but the data bus inversion signal is indicated as DBI [7:0].

In the semiconductor device 10, on the read operation, the data bus inversion circuit 21 generates the data bus inversion signal DBI [7:0]. The data bus inversion circuit 21 receives the read data DATA [63:0] from the read/write bus, carries out a predetermined processing (the above-mentioned majority processing) on it, generates the data bus inversion signal DBI [7:0], and supplies it to the error-detecting code generating circuit 20 via the DM/DBI bus.

Inasmuch as the data mask signal and the data bus inversion signal are input/output at a common terminal in this exemplary embodiment, either one is used exclusively or both are not used. This setting can be switched by setting the operation mode in the mode register in the control circuit 18.

Operation which the semiconductor device 10 carries out will be described in brief in a case where commands related to this invention are supplied from the outside.

When the external memory control signals CS and RAS have the L level and the external memory control signals CAS and WE have the H level on the rising edge of the clock signal CK from the outside (on the trailing edge of the inverted clock signal /CK), the command decoder 16 is supplied with the ACT command. In this event, among the internal command signals of the command decoder 16, the internal active signal changes from the L level to the H level. Responsive to a change to the H level of the internal active signal, an active operation is carried out in the semiconductor device 10. More specifically, the row decoder 13 and the address buffer in the control circuit 18 are supplied with the active/inactive control signal indicative of activation and are activated. While the ACT command is supplied, the address signal supplied from the outside is latched to the address buffer. And, the activated row decoder 13 decodes the latched address signal to select and drive the word line of the memory cell array 11. By supplying the ACT command, the sense amplifier array 15 and the data input/output portion 19 also are supplied with the active/inactive control signal indicative of activation and are activated. The control circuit 19 adjusts timing of the active/inactive control signal indicative of activation therein to supply it to the sense amplifier array 15. Supplied with the timing adjusted signal, the sense amplifier array 15 amplifies the voltages of the bit lines.

In the write operation, when the external memory control signals CS, CAS, and WE have the L level and the external memory control signal RAS has the H level on the rising edge of the clock signal CK, the command decoder in the control circuit 18 is supplied with the WRITE command. In this event, among the internal command signals of the command decoder, the internal write signal changes from the L level to the H level. Responsive to the change to the H level of the internal write signal, the write operation is carried out in the semiconductor device 10. More specifically, the address buffer, which is already activated by the ACT command, latches the address signal supplied from the outside together with the WRITE command this time, and the column decoder 14 activated by the WRITE command selects the bit line of the memory cell array 11 on the basis of the latched address signal. The control circuit 18 controls a timing of the write control signal to supply it to the data input/output portion 19. Supplied with the write control signal, the data input/output portion 19 drives the selected bit lines of the memory cell array 11 together with the sense amplifier array 15 via the read/write bus and the column switches to write the write data supplied from the outside in the memory cells.

In the read operation, when the external memory control signals CS and CAS have the L level and the external memory control signals RAS and WE have the H level on the rising edge of the clock signal CK, the command decoder in the control circuit 18 is supplied with the READ command. In this event, among the internal command signals of the command decoder, the internal read signal changes from the L level to the H level. Responsive to the change of the H level of the internal read signal, the read operation is carries out in the semiconductor device 10. More specifically, the address buffer, which is already activated by the ACT command, latches the address signal supplied from the outside together with the READ command this time, and the column decoder 14 activated by the READ command selects the bit line of the memory cell array 11 on the basis of the latched address signal. The control circuit 18 controls a timing of the read control signal to produce it. Supplied with the read control signal, the data input/output portion 19 is supplied with the voltages of the bit lines of the memory cell array 11 that are amplified by the sense amplifier array 15 as the read data DATA [63:0] via the column switches and the read/write bus, is supplied with the CRC code CRC [7:0] generated by the error-detecting code generating circuit 21 via the CRC signal line, and produce both data to the outside via the data input/output terminals DQ.

On shifting to a standby state following to the read operation or the write operation, when the external memory control signals CS, RAS and WE have the L level and the external memory control signal CAS has the H level on the rising edge of the clock signal CK, the command decoder in the control circuit 18 is supplied with the PRE command. In this event, among the internal command signals of the command decoder, the internal precharge signal changes from the L level to the H level. Responsive to the change of the H level of the internal precharge signal, the precharge operation is carried out in the semiconductor device 10. More specifically, the row decoder 13 is supplied with the active/inactive control signal indicative of inactivation and is inactivated, the word lines of the memory cell array 11 are turned to an non-selected state, the bit lines of the memory cell array 11 are precharged to the predetermined voltage, and therefore the semiconductor device 10 is put into a standby state (IDLE). By supplying the PRE command, the column decoder 14, the sense amplifier array 15, and the data input/output portion 19 also are supplied with the active/inactive control signal indicative of inactivation and are inactivated.

On setting the operation mode in the semiconductor device 10, when all of the external memory control signals CS, RAS, WE, and CAS have the L level on the rising edge of the clock signal CK, the command decoder in the control circuit 18 is supplied with the MRS command. The mode register in the control circuit 18 is supplied with the MRS command and generates a code (an MRS code) indicative of the operation mode in which the semiconductor device 10 shifts when a logic of the supplied address takes a predetermined logic. The MRS code is latched in the mode register and is used to control the operations of the respective circuits in the semiconductor device 10 by the control circuit 18 (e.g. setting of the burst length BL or whether or not mistaken data write operation to the memory cells of the data input/output portion 19 is allowed)

When the MRS command is supplied and the semiconductor device 10 shifted to the above-mentioned test operation mode is supplied with the ACT command, the READ command, or the like, the semiconductor device 10 carries out the above-mentioned operation to which the supplied command instructs.

The MRS code is held in the mode register until the time when the MRS command is supplied again.

Next, the description will proceed to configuration of the error-detecting code generating circuit 10 illustrated in Fig. 9.

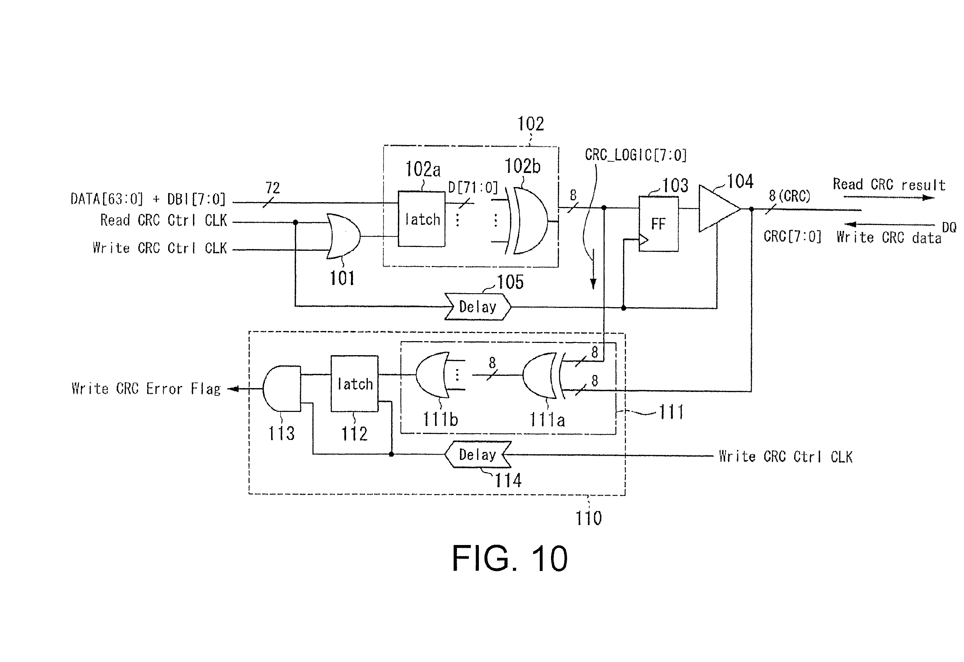

Fig. 10 is a block diagram showing the configuration of the error-detecting code generating circuit 10.

As shown in Fig. 10, the error-detecting code generating circuit 10 comprises an OR circuit 101, an 8-bit CRC code generating circuit 102, a flip-flop circuit 103, a buffer circuit 104, a delay circuit 105, and an 8-bit CRC code decision circuit 110. The 8-bit CRC code decision circuit 110 comprises an 8-bit CRC code comparison circuit 111, a latch circuit 112, an AND circuit, and a delay circuit 114.

The OR circuit 101 calculates a logical OR of the control signal Read CRC Ctrl CLK and the control signal Write CRC Ctrl CLK which are supplied from the control circuit 18 to supply an output signal of a calculated result to a latch circuit 102a constituting the 8-bit CRC code generating circuit 102. When either the control signal Read CRC Ctrl CLK or the control signal Write CRC Ctrl CLK becomes an active level (the H level), the OR circuit 101 supplies the output signal of the H level to the latch circuit 102a.

The 8-bit CRC code generating circuit 102 comprises the latch circuit 102a and a 72-input exclusive OR circuit 102b.

The latch circuit 102a holds the data (the read data DATA [63:0] or the write data DATA [63:0]) and the data bus inversion signal DBI [7:0] supplied via the read/write bus and the DM/DBI bus, respectively, when the output signal of the OR circuit 101 becomes the H level and supplies held data to the 72-input exclusive OR circuit 102b as data signal D [71:0].

Herein, the data signal D [71:0] comprises upper data D [71:8] corresponding to the data (the read data DATA [63:0] or the write data DATA [63:0]) and data signal D [7:0] corresponding to the data bus inversion signal DBI [7:0].

The 72-input exclusive OR circuit 102b calculates an XOR (an exclusive OR) using the data signal D [71:0] supplied from the latch circuit 102a to generate an 8-bit CRC logic code CRC_LOGIC [7:0] (a cyclic redundancy logic code) as a CRC calculated result (details thereof will later be described).

The delay circuit 105 is set with a delay time having a time amount which is required to a latch operation of the latch circuit 102a and a calculating operation of the 72-input exclusive OR circuit 102b, and supplies a signal delaying the control signal Read CRC Ctrl CLK to the flip-flop circuit 103 and the buffer circuit 104.

The flip-flop circuit 103 holds the CRC logic code CRC_LOGIC [7:0] serving as the calculated result of the 72-input exclusive OR circuit 102b when the delayed control signal Read CRC Ctrl CLK becomes the active level (the H level) to supply the held signal to the buffer circuit 104. The buffer circuit 104 supplies the CRC logic code CRC_LOGIC [7:0] held in the flip-flop circuit 103 as the CRC code CRC [7:0] to the data input/output portion 19 when the delayed control signal Read CRC Ctrl CLK becomes the active level (the H level). On read operation, the data input/output portion 19 produces the CRC code CRC [7:0] from the data input/output terminals DQ as a CRC result (Read CRC result) on reading of the semiconductor device 10.

The 8-bit CRC code decision circuit 110 comprises the 8-bit CRC code comparison circuit 111, the latch circuit 112, the AND circuit 113, and the delay circuit 114. In addition, the 8-bit CRC code comparison circuit 111 comprises an exclusive OR circuit 111a and an OR circuit 111b.

The exclusive OR circuit 111 a calculates XOR (exclusive OR) of the CRC logic code CRC_LOGIC [7:0] acting as the calculated result of the 72-input exclusive OR circuit 102b and the CRC code CRC [7:0] acting as the output signal of the buffer circuit 104 to supply a calculated result to the OR circuit 111b. The exclusive OR circuit 111a comprises, for example, eight XOR circuits (exclusive OR circuits). Each of the eight XOR circuits calculates an exclusive OR of one bit of the CRC logic code CRC_LOGIC [7:0] and one bit of the CRC code CRC [7:0] (e.g. a CRC logic code CRC_LOGIC [i] and a CRC code CRC [7:0] as i = 0 to 7). The eight XOR circuits supply the output signal of eight bits in total to the OR circuit 111b. When logic levels of the CRC logic code CRC_LOGIC [7:0] and logic levels of the CRC code CRC [7:0] entirely coincide with one another, the exclusive OR circuit 111 a produces the output signal of the L level wholly. On the other hand, when the logic levels of the CRC logic code CRC_LOGIC [7:0] and the logic levels of the CRC code CRC [7:0] do not coincide with at least one, the exclusive OR circuit 111 a produces the L level for coincidence bit or bits and the H level for mismatch bit or bits.

The OR circuit 111 b calculates OR of the output signal of eight bits from the exclusive OR circuit 111a to supply a calculated result to the latch circuit 112. Accordingly, the 8-bit CRC code comparison circuit 111 supplies the output signal of the L level to the latch circuit 112 when the logic levels of the CRC logic code CRC_LOGIC [7:0] and the logic levels of the CRC code CRC [7:0] entirely coincide with one anther, and supplies the output signal of the H level to the latch circuit 112 when there are at least one mismatch logic level.

The delay circuit 114 is set with a delay time of a time amount which is required to the operation of the 8-bit CRC code generating circuit 102 (the latch operation of the latch circuit 102a and the calculation operation of the 72-input exclusive OR circuit 102b) and the composition operation of the 8-bit CRC code comparison circuit 111, and supplies a signal delaying the control signal Write CRC Ctrl CLK to the latch circuit 112 and the AND circuit 113.

The latch circuit 112 holds a comparison result of the 8-bit CRC code comparison circuit 111 when the delayed control circuit Write CRC Ctrl CLK becomes the active level (the H level) to supply a held signal to the AND circuit 113. The AND circuit 113 calculates AND of the comparison result of the 8-bit CRC code comparison circuit 111 held in the latch circuit 112 and the delayed control signal Write CRC Ctrl CLK to supply the decision result signal Write CRC Error Flag as a calculated result to the alert signal output portion 22.

That is, the 8-bit CRC code decision circuit 110, which comprises the 8-bit CRC code comparison circuit 111, the latch circuit 112, the AND circuit 113, and the delay circuit 114, supplies the decision result signal Write CRC Error Flag having the L level to the alert signal output portion 22 when the logic levels of the CRC logic code CRC_LOGIC [7:0] and the logic levels of the CRC code CRC [7:0] entirely coincide with one another, and supplies the decision result signal Write CRC Error Flag having the H level to the alert signal output portion 22 when there is at least one mismatch logic level.

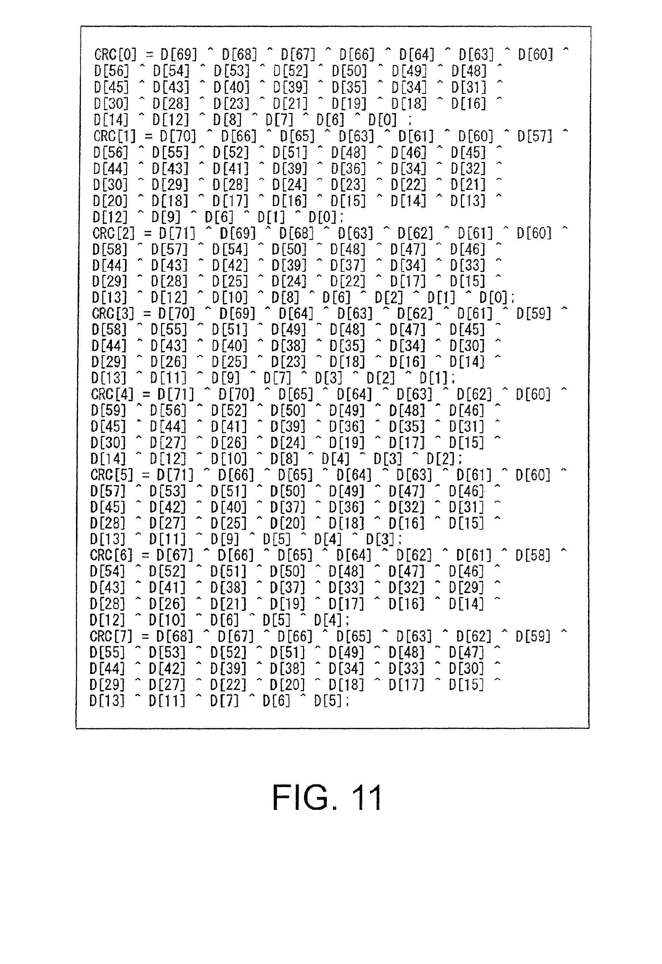

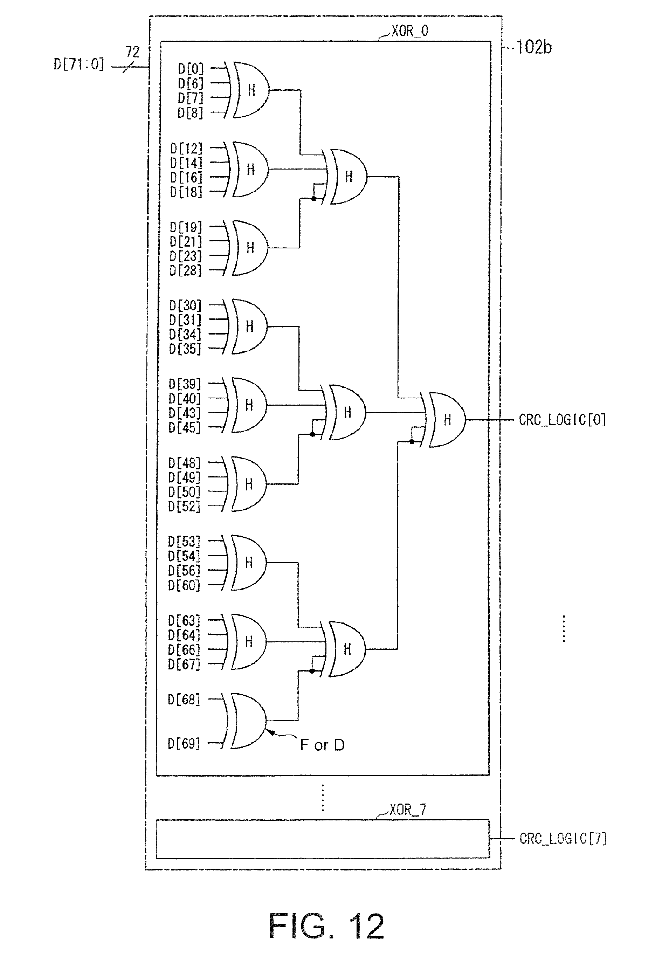

Referring now to Figs. 11 and 12, the description will proceed to an example of the logic operation in which the 8-bit CRC code generating circuit 102 in the error-detecting code generating circuit 20 carries out.

Fig. 11 is a view showing an example of a logic of error-detecting code generation where the 72-input exclusive OR circuit 102b carries out. Fig. 12 is a block diagram showing a configuration of an (i + l)-th multiple-input exclusive OR circuit XOR_i in the 72-input exclusive OR circuit 102b.

The 72-input exclusive OR circuit 102b comprises first through eighth multiple-input exclusive OR circuits XOR_i (i = 0 to 7).

As shown in Fig. 12, the first multiple-input exclusive OR circuit XOR_0 comprises twelve exclusive OR circuits XOR_H (the exclusive OR circuit shown in Fig. 6) and one exclusive OR circuit XOR_F (the exclusive OR circuit shown in Fig. 4) or one exclusive OR circuit XOR_D (the exclusive OR circuit shown in Fig. 2).

Although Fig. 12 shows a circuit configuration of the first multiple-input exclusive OR circuit XOR_0 in details, each of the second through the eighth multiple-input exclusive OR circuit XOR_1 to XOE_7 comprises exclusive OR circuits in the manner which is similar to that of the first multiple-input exclusive OR circuit XOR_0 and carries out logic operation shown in Fig. 11.

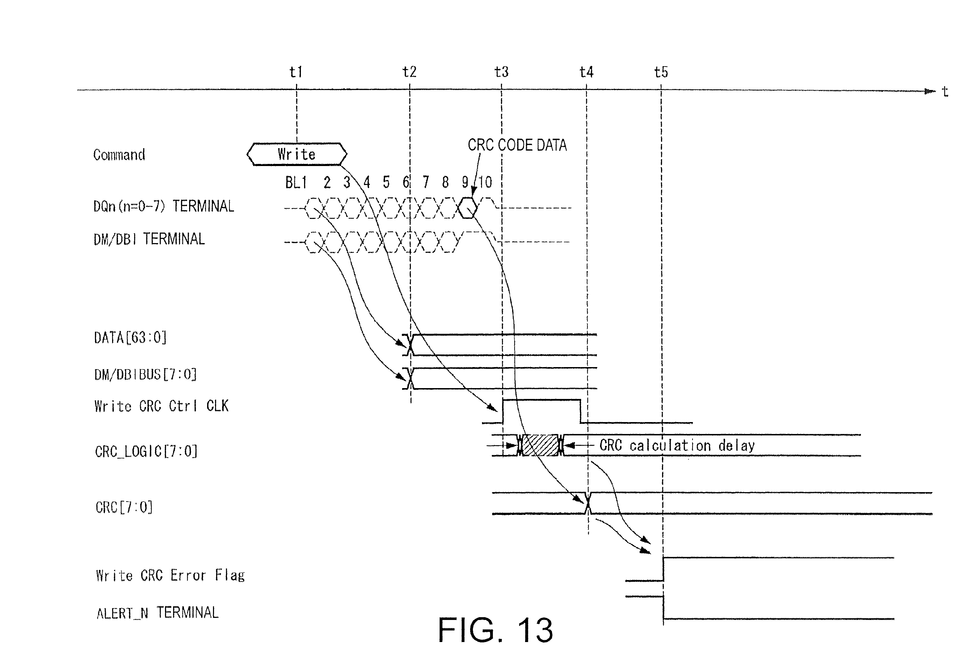

Referring now to Fig. 13, description will be made as regards a write operation of the semiconductor device 10.

Fig. 13 is a timing chart of the write operation (eight IO inputs) of the semiconductor device 10.

In Fig. 13, a change of the input signal occurring in the data input/output terminals DQ shows an input signal of one data input/output terminal DQ.

At a first time instant t1, the memory controller supplies the semiconductor device 10 with the WRITE command.

It is assumed that the memory controller supplies the DM/DBI terminal with the data bus inversion signal without the data mask signal. When the data mask signal and the data bus inversion signal are not supplied, the memory controller fixes the DM/DBI terminal to a logic level of either the high level or the low level.

The data input/output portion 19 receives the data bus inversion signal from the memory controller via the DM/DBI terminal, and supplies the data bus inversion signal DBI [7:0] through the DM/DBI bus to the error-detecting code generating circuit 20 at second and third time instants t2 to t3.

In addition, the data input/output portion 19 receives the write data (64 bits in total) from the memory controller via the data input/output terminals DQn (n = 0 to 7), and supplies the write data DATA [63:0] through the read/write bus to the error-detecting code generating circuit 20 at the second and third time instants t2 to t3. Furthermore, the data input/output portion 19 extracts the CRC code from the ninth bit among the write data transmitted from the memory controller, and supplies the CRC code [7:0] through the CRC signal line to the error-detecting code generating circuit 20.

At the third time instant t3, the error-detecting code generating circuit 20 is activated by the control signal Write CRC Ctrl CLK supplied from the control circuit 18, and generates the CRC logic code CRC_LOGIC [7:0] on the basis of the write data DATA [63]0] supplied from the data input/output portion 19 through the read/write bus and the data bus inversion signal DBI [7:0] supplied from the data input/output portion 19 through the DM/DBI bus.

At a fourth time instant t4, the error-detecting code generating circuit 20 compares the CRC logic code CRC_LOGIC [7:0] with the CRC code CRC [7:0] supplied from the date input/output portion 19 through the CRC signal line.

At a fifth time instant t5, when the CRC logic code CRC_LOGIC [7:0] does not coincide with the CRC code CRC [7:0] supplied from the data input/output portion 19 through the CRC signal line, the error-detecting code generating circuit 20 makes the decision result signal Write CRC Error Flag the active level (the H level) to supply it to the alert signal output portion 22.

When receives the decision result signal Write CRC Error Flag having the active level, the alert signal output portion 22 supplies the alert signal having the active level (the L level) from the ALERT_N terminal to the memory controller to make a request for the memory controller so as to resend the write data or the data bus inversion signal.

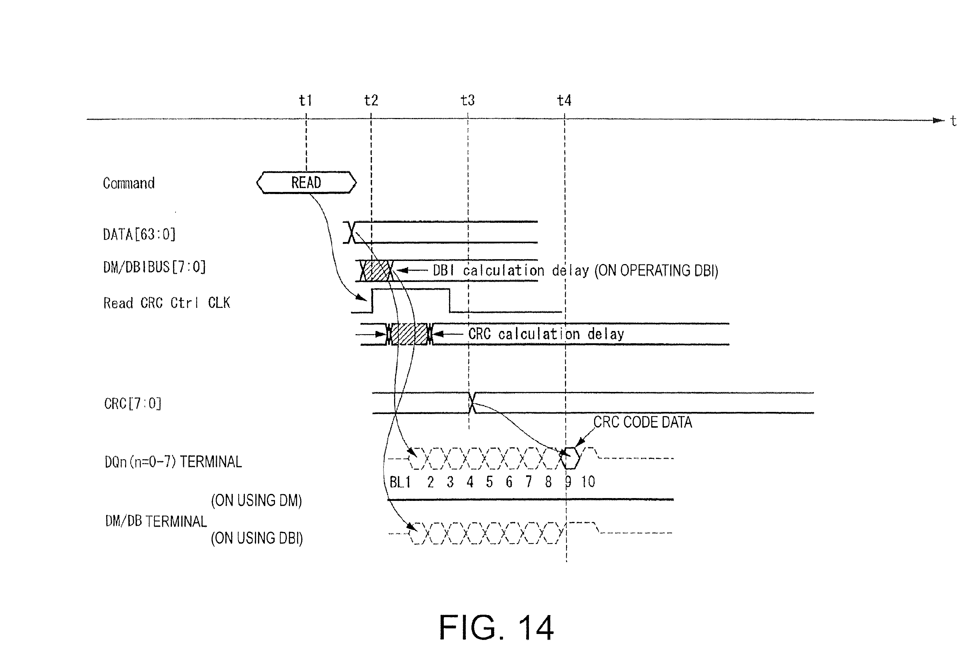

Next, referring to Fig. 14, description will be mad as regards a read operation of the semiconductor device 10.

Fig. 14 is a timing chart of the read operation (eight IO outputs) of the semiconductor device 10.

In Fig, 14, a change of the input signal occurring in the data input/output terminals DQ shows an input signal of one data input/output terminal DQ.

At a first time instant t1, the memory controller supplies the semiconductor device 10 with the READ command. It will be assumed that the semiconductor device 10 supplies the DM/DBI terminal with the data bus inversion signal without the data mask signal. When the semiconductor device 10 does not supply the data mask signal and the data bus inversion signal, the memory controller fixes the DM/DBI terminal to a logic level of either the high level or the low level.

The data bus inversion circuit 21 receives the read data DATA [63:0] from the memory cell array 11 through the read/write bus, carries out the predetermined processing (the above-mentioned majority processing) to generate the data bus inversion signal DBI [7:0], and supplies it the error-detecting code generating circuit 10 and the data input/output portion 19 through the DM/DBI bus.

At a second time instant t2, the error-detecting code generating circuit 20 is activated by the control signal Read CRC Ctrl CLK supplied from the control circuit 18. The error-detecting code generating circuit 20 generates, as the CRC calculated result, the 8-bit CRC logic code CRC_LOGIC [7:0] on the basis of the read data DATA [63:0] read out of the memory cell array 11 through the read/write bus and the data bus inversion signal DBI [7:0] supplied from the data bus inversion circuit 21 through the DM/DBI bus.

In addition, at a third time instant t3, the error-detecting code generating circuit 20 supplies the CRC logic code CRC_LOGIC [7:0] as the CRC code CRC [7:0] to the data input/output portion 19 through the CRC signal line.

The data input/output portion 19 successively produces the read data of eight bits (64 bits in total) from the respective data input/output terminals DQn (n = 0 to 7), and produces the data bus inversion signal (8 bits) corresponding to the bits of the read data, respectively, from the DM/DBI terminal in synchronism with the read data (BL1 to BL8). In addition, at a fourth time instant t4 after end of production of the read data of BL8, the data input/output portion 19 produces the CRC code as the read data of BL9 from the respective data input/output terminals DQn (n = 0 to 7).

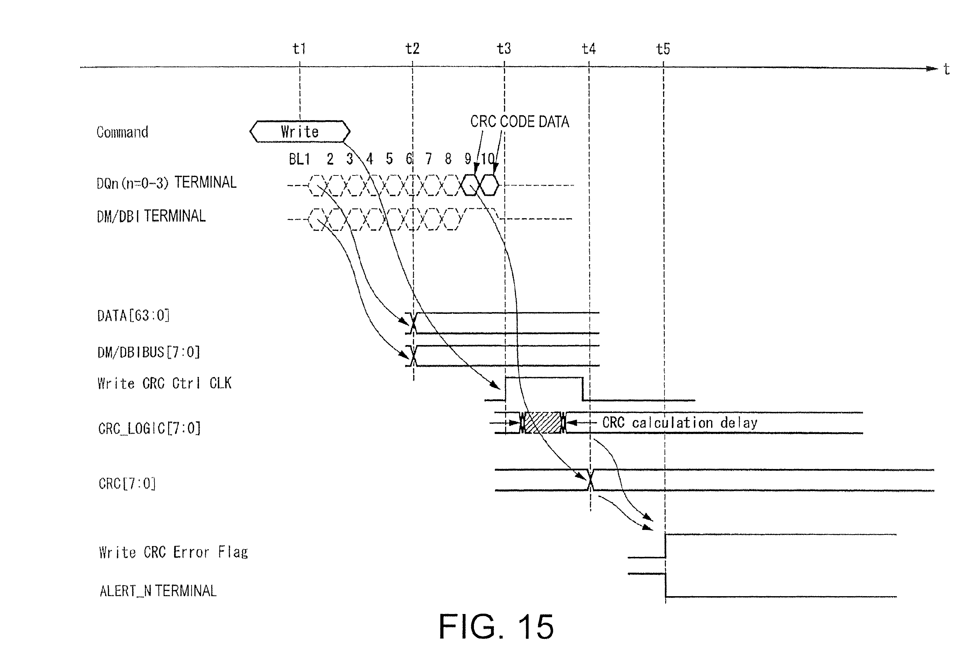

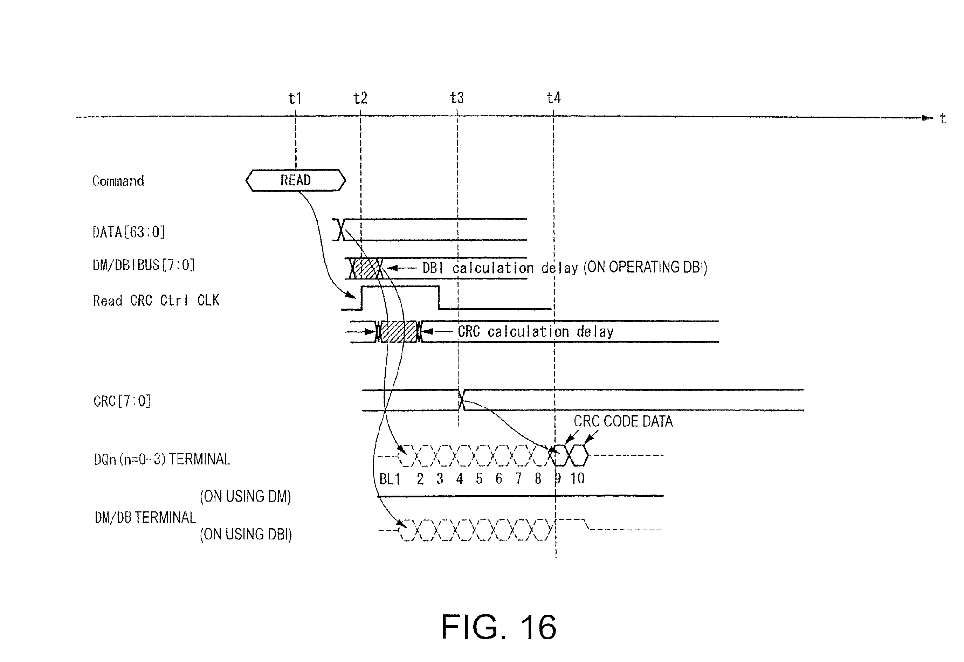

Next, referring to Figs. 15 and 16, description will be made as regards a write operation and a read operation of a semiconductor device in which the IO configuration of the semiconductor device 10 is changed from the X8IO configuration into an X4IO configuration, as a modified example of this exemplary embodiment. It will be assumed that the semiconductor device having the X4IO configuration which will later be described is one where only the IO configuration of the semiconductor device is changed, specifically, one where the data input/output terminals DQn of the semiconductor device 10 illustrated in Fig. 9 is changed to data input/output terminals DQn (n = 0 to 3) and other configurations are substantially equivalent to that of the semiconductor device 10. In Figs. 15 and 16, the description will proceed to a case of BL8 operation in the X4IO configuration (operation where the memory cell data of 4 X 8 = 32 bits are produced at the burst length of eight from the four data input/output terminals DQ. In this event, an unassigned read/write bus (a bus wiring in which the read data DATA [63-32] or the write data DATA [63:32] are transferred) is fixed to either the H level or the L level. Inasmuch as the error-detecting code generating circuit 20 uses one similar to the X8IO configuration, the CRC calculated result having the bit number similar to that of the X8IO configuration is required in operation of the X4IO configuration. For this purpose, the X4IO configuration having less IO number uses a scheme for producing the CRC calculated result having 8 bits in total by using bits double in number that consists of the ninth and the tenth bits.

Fig. 15 is a timing chart of the write operation (four IO inputs) of the semiconductor device 10. Fig. 16 is a timing chart of the read operation (four IO outputs) of the semiconductor device 10.

Inasmuch as the operations in the case of the X4IO configuration is substantially similar to the operation in the case of the X8IO configuration as shown in Figs. 15 and 16, only differences will be described.

First, as shown in Fig. 15, the data input/output portion 19 receives the write data (32 bits in total) from the memory controller through the respective data input/output terminals DQn (n = 0 to 3) at a first time instant t1, and supplies the write data DATA [63:0] through the read/write bus to the error-detecting code generating circuit 20 at second and third time instants t2 and t3. Furthermore, the data input/output portion 19 extracts the CRC code from the ninth and the tenth bits among the write data transmitted from the memory controller, and supplies the CRC code CRC [7:0] through the CRC signal line to the error-detecting code generating circuit 20.

In addition, as shown in Fig. 16, the data input/output portion 19 successively produces the read data having 32 bits from the respective data input/output terminals DQn (n = 0 to 3), and produces the data bus inversion signal corresponding to the respective bits of the read data from the DM/DBI terminal in synchronism with the read data (BL1 to BL8). At a fourth time instant t4 after the end of production of the read date of BL8, the data input/output portion 19 produces the CRC code as the read data (8 bits in total) of BL9 and BL 10 from the respective data input/output terminals DQn (n = 0 to 3).

In the manner which is described above, the semiconductor device 10 comprises: the memory cell array (the memory cell array 11) including a plurality memory cells which store data and which correspond to bit lines and word lines; the error-detecting code generating circuit (the error-detecting code generating circuit 20) for generating the cyclic redundancy logic code on the basis of the data read out of the memory cell array or the data to be written in the memory cell array; and the data input/output portion (the data input/output portion 19) which adds the cyclic redundancy logic code to the data read out of the memory cell array to produce the added data as the read data to the outside of the semiconductor device via the data input/output terminals or which is supplied with the write data from the outside of the semiconductor device to produce the data to be written in the memory cell array to the error-detecting code generating circuit. In addition, the error-detecting code generating circuit is characterized by comprising the multiple-input logic circuit (the 72-input exclusive OR circuit 102b) whose three or more input terminals are supplied with the data read out of the memory cell array or with the data to be written in the memory cell array.

According to the semiconductor device 10 according to this invention, it is possible to carry out the CRC operation at high speed and to carry out the write operation and the read operation of the semiconductor device 10 at high speed because the semiconductor device 10 comprises the error-detecting code generating circuit 20 including the multiple-input exclusive OR circuit in which balance between the operation rate and the driving ability is regulated.

A technical idea of this application is applicable to the semiconductor device having the CRC function. Furthermore, a connection method and a circuit form of the respective blocks disclosed in the drawings and a circuit for generating other control signals are not limited to the circuit form disclosed in the embodiments. For example, in the exemplary embodiments, as a unit circuit portion constituting the error-detecting code generating circuit 20, the exclusive OR circuit XOR_D (the first 2-input logic circuit) and the exclusive OR circuit XOR_F (the second 2-input logic circuit) each of which carries out an exclusive OR operation (the first logic operation) on the logic levels of the two input terminals are disclosed. This unit circuit portion may comprise the exclusive NOR circuit XNR_C (the first 2-input logic circuit) and the exclusive NOR circuit XNR_E (the second 2-input logic circuit) each of which carries out an exclusive NOR operation (see, Fig. 5). In this event, if it is provided with an inverter circuit logically inverting at the input node side of the data input/output portion 19, it is unnecessary to logically inverting the CRC code CRC [7:0] (the cyclic redundancy code) at the side of the error-detecting code generating circuit 20, and it is therefore to make a circuit for carrying out a last stage operation of the error-detecting code generating circuit 10 the exclusive NOR circuit XNR_C (the second 2-input logic circuit) as it is. Alternatively, it is not provided with the inverter circuit logically inverting at the input side of the data input/output portion 19, it may make the circuit for carrying out the last stage operation the exclusive OR circuit XOR_D (the first 2-input logic circuit).

The technical ides of the semiconductor device of this invention can be applicable to various semiconductor devices. Although examples of the memory are mainly disclosed in the exemplary embodiments of this invention, this invention is not limited thereto, this invention can be applicable to semiconductor devices other than the memory, for example, semiconductor devices in general such as a CPU (Central Processing Unit), an MCU (Micro Control Unit), a DSP (Digital Signal Processor), an ASIC (Application Specific Integrated Circuit), an ASSP (Application Specific Standard Circuit), and so on.

In addition, product configurations of the semiconductor devices to which this invention is applicable can be applied to semiconductor devices such as a SOC (System On Chip), an MCP (Multi Chip Package), a POP (Package On Package), or the like. This invention can be applied to the semiconductor devices having their any product configurations or package configurations.

In addition, the transistors may be field effect transistors (FETs). The transistors can be applicable to various FETs such as not only MOS (Metal Oxide Semiconductor) but also MIS (Metal-Insulator Semiconductor), TFT (Thin Film Transistor), or the like. This invention can be applicable to various FETs such as transistors. Furthermore, it may comprise bipolar transistors in part in the device,

In addition, PMOS transistors (P-channel type MOS transistors) act on behalf of second conductive-type transistors while NMOS transistors (N-channel type MOS transistors) act on behalf of first conductive-type transistors.

Furthermore, it is possible to make variety of combinations and selections of various disclosed elements within the bounds of claims of this invention. That is to say, it is apparent that the present invention may include various modifications and changes which can be made by those of ordinary skill in the art according to all disclosure including claims and technical ideas.

## Claims

1. A device comprising:
first and second logic circuits each comprising;
first and second input terminals receiving first and second input signals, respectively, and
a first output terminal outputting a first output signal, and
each of the first and second logic circuits performing a first logic operation on the first and second input signals to generate the first output signal, and
a third logic circuit comprising;
third and fourth input terminals receiving the first output signals supplied from the first and second logic circuits, respectively, and
a second output terminal outputting a second output signal, and
the third logic circuit performing the first logic operation on the first output signals supplied from the first and second logic circuits to generate the second output signal, and
wherein each of the first and second logic circuits is smaller in size than the third logic circuit and is smaller in driving ability than the third logic circuit.

2. The device as claimed in claim 1, wherein the first logic operation is an exclusive NOR operation.

3. The device as claimed in claim 1, wherein the first logic operation is an exclusive OR operation.

4. The device as claimed in claims 1 through 3, further comprising;
fourth, fifth, sixth and seventh logic circuits each comprising,
fifth and sixth input terminals receiving third and fourth input signals, respectively, and
a third output terminal, and
wherein each of fourth, fifth, sixth and seventh logic circuits performing the first logic operation on the fifth and sixth input signals, the fourth and sixth logic circuits supply the first input signals respectively to the first and second logic circuits through the third output terminal thereof, and the fifth and seventh logic circuits supply the second input signals respectively to the first and second logic circuits through the third output terminal thereof.

5. A device comprising:
first and second logic circuits each comprising;
first and second input terminals receiving first and second input signals, respectively,
a first output terminal outputting a first output signal,
a first circuit portion configured to drive the first output terminal to generate the first output signal in response to the first input signal when the second input signal takes a first logic level, and
a second circuit portion configured to transfer the first input signal to the first output terminal to output the first output signal when the second input signal takes a second logic level that is different form the first logic level, and
a third logic circuit comprising;
third and fourth input terminals receiving the first output signals supplied from the first and second logic circuits, respectively,
a second output terminal outputting a second output signal,
a third circuit portion configured to drive the second output terminal to generate the second output signal in response to the first output signal supplied from the first logic circuit when the first output signal supplied from the second logic circuit takes a third logic level, and
a fourth circuit portion configured to drive the second output terminal to generate the second output signal in response to the first output signal supplied from the first logic circuit when the first output signal supplied from the second logic circuit takes a fourth logic level that is different from the third logic level.

6. The device as claimed in claim 5, wherein each of the first, second and third logic circuits includes an exclusive NOR circuit.

7. The device as claimed in claim 5, wherein each of the first, second and third logic circuits includes an exclusive OR circuit.

8. The device as claimed in claims 5 through 7, wherein the number of transistors of each of the first and second logic circuits is smaller than the number of transistors of the third logic circuit.

9. The device as claimed in claim 5 through 8, further comprising; fourth, fifth, sixth and seventh logic circuits each comprising,
fifth and sixth input terminals receiving third and fourth input signals, respectively,
a third output terminal,
a fifth circuit portion configured to drive the third output terminal in response to the fourth input signal when the fifth input signal takes the first logic level, and
a sixth circuit portion configured to transfer the third input signal to the third output terminal when the fourth input signal takes the second logic level that is different form the first logic level, and
wherein the fourth and sixth logic circuits supply the first input signals respectively to the first and second logic circuits through the third output terminal thereof, and the fifth and seventh logic circuits supply the second input signals respectively to the first and second logic circuits through the third output terminal thereof.

10. A device comprising:
first and second logic circuits each comprising;
first and second input terminals,
a first output terminal,
a first inverter coupled to the first input terminal at an input node thereof and including an output node,
a second inverter coupled to the second input terminal at an input node thereof and coupled to the first output terminal at an output node thereof and including first and second power supply node, the first power supply node being coupled to the output node of the first inverter, and the second power supply node being coupled to the first input terminal, and
a first transfer gate coupled between the second input terminal and the first output terminal and including first and second control node, the first control node being coupled to the output node of the first inverter, and the second control node coupled to the first input terminal, and
a third logic circuit comprising;
third and fourth input terminals coupled to the first output terminals of the first and second logic circuits, respectively,
a second output terminal,
a third inverter coupled to the third input terminal at an input node thereof and including an output node,
a fourth inverter coupled to the fourth input terminal at an input node thereof and including an output node,
a first circuit portion comprising,
a third power supply node,
first and second transistors coupled in series between the third power supply node and the second output terminal, the first transistor being coupled to the third terminal at a control electrode thereof, the second transistor being coupled to the fourth terminal at a control electrode thereof, and
a third transistor coupled between the second output terminal and the output node of the fourth inverter and coupled to the output node of the third inverter at a control electrode thereof, and
a second circuit portion comprising,
a fourth power supply node,
fourth and fifth transistors coupled in series between the fourth power supply node and the second output terminal, the fourth transistor being coupled to the output node of the third inverter at a control electrode thereof, the fifth transistor being coupled to the output node of the fourth inverter at a control electrode thereof, and
a sixth transistor coupled between the second output terminal and the output node of the third inverter and coupled to the output node of the fourth inverter at a control electrode thereof.

11. The device as claimed in claim 10, wherein each of the first, second and third logic circuits includes an exclusive NOR circuit.

12. The device as claimed in claim 10, wherein each of the first, second and third logic circuits includes an exclusive OR circuit.

13. The device as claimed in claims 10 through 12, wherein the number of transistors of each of the first and second logic circuits is smaller than the number of transistors of the third logic circuit.

14. The device as claimed in claims 10 through 13, further comprising; fourth, fifth, sixth and seventh logic circuits each comprising,
fifth and sixth input terminals,
a third output terminal,
a fifth inverter coupled to the fifth input terminal at an input node thereof and including an output node,
a sixth inverter coupled to the sixth input terminal at an input node thereof and coupled to the third output terminal at an output node thereof and including fifth and sixth power supply nodes, the fifth power supply node being coupled to the output node of the fifth inverter, and the sixth power supply node being coupled to the fifth input terminal, and
a second transfer gate coupled between the sixth input terminal and the third output terminal and including third and fourth control node, the third control node being coupled to the output node of the fifth inverter, and the fourth control node coupled to the fifth input terminal, and
wherein the third output terminals of the fourth and sixth logic circuits are coupled to the first input terminal of the first and second logic circuits, respectively, and the third output terminals of the fifth and seventh logic circuits are coupled to the second input terminal of the first and second logic circuits, respectively.
